# EUROPEAN PATENT APPLICATION

(11) **EP 3 982 414 A1**
(43) Date of publication of application: **13.04.2022**
(21) Application number: 20826881.3
(22) Date of filing: 19.06.2020
(51) Int. Cl.: H01L 27/32, H01L 51/52, G02B 5/20

(54) **ELECTRONIC DEVICE INCLUDING DISPLAY HAVING IRREGULAR PATTERN**

(30) Priority: 19.06.2019 KR 20190073119
(71) Applicant: Samsung Electronics Co., Ltd., Gyeonggi-do 16677 (KR)
(72) Inventor: JUNG, Songhee, Suwon-si Gyeonggi-do 16677 (KR); SHIN, Sungyoung, Suwon-si Gyeonggi-do 16677 (KR); SHIN, Hyunchang, Suwon-si Gyeonggi-do 16677 (KR); YANG, Byungduk, Suwon-si Gyeonggi-do 16677 (KR); HER, Yongkoo, Suwon-si Gyeonggi-do 16677 (KR); KIM, Kwangtai, Suwon-si Gyeonggi-do 16677 (KR); YEOM, Donghyun, Suwon-si Gyeonggi-do 16677 (KR)
(74) Representative: HGF
(86) International application number: PCT/KR2020/008011
(87) International publication number: WO 2020/256496

(57) **Abstract**

An electronic device according to various embodiments, comprises a sensor module configured to emit or detect light; and a display disposed above the sensor module, the display comprising a first area corresponding to a location of the sensor module and a second area which is a remaining area other than the first area, wherein the display comprises: a pixel layer comprising pixels; an electrode layer disposed beneath the pixel layer, the electrode layer comprising electrodes electrically connected to the pixels; conductive patterns electrically connected to the pixels and the electrodes; and nonconductive patterns between the pixels, wherein the conductive patterns are spaced apart from each other, at different intervals in the first area, and wherein the nonconductive patterns are spaced apart from each other, at different intervals in the first area.

## Description

### Technical Field

Various embodiments disclosed in the document relate to an electronic device including a display having an irregular pattern formed thereon.

### Background Art

Not only the functions provided by an electronic device, but also the exterior design of the electronic device, the visually recognized material, and the like may be important factors in connection with the user's selection of the electronic device. In this regard, an electronic device including a display may have a reduced thickness or width of a bezel formed along the edge of the display, in order to improve the aesthetic appearance. In order to form a thin bezel, sensors that would conventionally be disposed on the front surface of the electronic device may be disposed beneath the display, and this may reduce the thickness or width of the bezel by the area occupied by the sensor on the front surface of the electronic device. There is an ongoing effort to form a full display in most areas of the front surface of electronic devices.

### Disclosure of Invention

### Technical Problem

In order to expand the screen display area of a display, sensors that would conventionally be disposed on an edge of the electronic device may be disposed in an area beneath the display. Light emitted by sensors disposed in the area beneath the display, or light received by the sensors may diffract when passing through various wires, electrodes, metal members, which constitute the display, or intervals formed between a combination thereof. Accordingly, there is a request for a solution for preventing the occurrence of noise formed by diffracted light.

### Solution to Problem

An electronic device according to various embodiments, comprises a sensor module configured to emit or detect light; and a display disposed above the sensor module, the display comprising a first area corresponding to a location of the sensor module and a second area which is a remaining area other than the first area, wherein the display comprises: a pixel layer comprising pixels; an electrode layer disposed beneath the pixel layer, the electrode layer comprising electrodes electrically connected to the pixels; conductive patterns electrically connected to the pixels and the electrodes; and nonconductive patterns between the pixels, wherein the conductive patterns are spaced apart from each other, at different intervals in the first area, and wherein the nonconductive patterns are spaced apart from each other, at different intervals in the first area.

An electronic device according to various embodiments, comprises a sensor module; and a display disposed above the sensor module, the display including a first area corresponding to a location of the sensor module and a second area which is a remaining area other than the first area. The display may include: a pixel layer including pixels configured to emit light outwards; an electrode layer disposed beneath the pixel layer, the electrode layer including electrodes electrically connected to the pixels; conductive patterns electrically connected to the pixels and the electrodes; and nonconductive patterns separating the pixels, respectively. In the first area, the display may include a filter configured to prevent scattering of light emitted or received by the sensor module.

### Advantageous Effects of Invention

According to various embodiments, distortion of light emitted from a sensor disposed in an area beneath a display or light delivered to the sensor may be reduced.

According to various embodiments, the light transmittance may be increased with regard to a partial area of a display, thereby increasing the amount of light received by a sensor disposed in an area beneath the display, or improving the sensitivity of the sensor.

### Brief Description of Drawings

FIG. 1 is a block diagram of an electronic device inside a network environment according to an embodiment;
FIG. 2 is a block diagram of a display device according to an embodiment;
FIG. 3 is a front view of an electronic device according to an embodiment;
FIG. 4 is an exploded diagram of the electronic device in FIG. 3 according to an embodiment;
FIG. 5A is a sectional view of the display in FIG. 4 according to an embodiment;
FIG. 5B is a sectional view of the display in FIG. 4 according to another embodiment;
FIG. 5C is a sectional view of the display in FIG. 4 according to still another embodiment;
FIG. 6 is a diagram illustrating wires and conductive patterns of a display in connection with area A in FIG. 3 according to an embodiment;
FIG. 7A is a diagram illustrating wires and conductive patterns of a display in connection with area B in FIG. 3 according to various embodiment;
FIG. 7B is a diagram illustrating wires and conductive patterns of a display in connection with area B in FIG. 3 according to another embodiment;
FIG. 7C is a diagram illustrating wires and conductive patterns of a display in connection with area B in FIG. 3 according to still another embodiment;
FIG. 7D is a diagram illustrating wires and conductive patterns of a display in connection with area B in FIG. 3 according to still another embodiment;
FIG. 8A is a sectional view of a display in connection with area A in FIG. 3 according to an embodiment;
FIG. 8B is a sectional view of a display in connection with area B in FIG. 3 according to an embodiment;
FIG. 8C is a sectional view of a display in connection with area B in FIG. 3 according to another embodiment;
FIG. 8D is a sectional view of a display in connection with area B in FIG. 3 according to still another embodiment;
FIG. 8E is a sectional view of a display in connection with area B in FIG. 3 according to still another embodiment;
FIG. 9A is a diagram illustrating wires and patterns included in respective layers of a display in connection with area A in FIG. 3 according to an embodiment;
FIG. 9B is a diagram illustrating wires and patterns included in respective layers of a display in connection with area B in FIG. 3 according to an embodiment;
FIG. 9C is a diagram illustrating wires and patterns included in respective layers of a display in connection with area B in FIG. 3 according to another embodiment;
FIG. 9D is a diagram illustrating wires and patterns included in respective layers of a display in connection with area B in FIG. 3 according to still another embodiment;
FIG. 10A is a diagram illustrating the path of light emitted from a sensor positioned beneath a display according to an embodiment;
FIG. 10B is a diagram illustrating the path of light emitted from a sensor positioned beneath a display according to another embodiment;
FIG. 11A is a diagram illustrating the path of light delivered to a sensor positioned beneath a display according to an embodiment;
FIG. 11B is a diagram illustrating the path of light delivered to a sensor positioned beneath a display according to another embodiment;
FIG. 12A is a diagram illustrating the position of a mask disposed on an electronic device according to an embodiment;
FIG. 12B is a diagram illustrating the position of a mask disposed on an electronic device according to another embodiment;
FIG. 12C is a diagram illustrating the position of a mask disposed on an electronic device according to still another embodiment;
FIG. 13A is a diagram illustrating the shape of a mask disposed on an electronic device according to an embodiment;
FIG. 13B is a diagram illustrating the shape of a mask disposed on an electronic device according to another embodiment;
FIG. 13C is a diagram illustrating the shape of a mask disposed on an electronic device according to still another embodiment;
FIG. 14 is a schematic diagram of a sensor disposed on an electronic device according to an embodiment;
FIG. 15 is a diagram illustrating wires and conductive patterns of a display in connection with area B in FIG. 3 according to still another embodiment;
FIG. 16 is a diagram illustrating wires and conductive patterns of a display in connection with area B in FIG. 3 according to still another embodiment;
FIG. 17A is a diagram illustrating disposition of pixels in connection with the display in FIG. 16 according to an embodiment;
FIG. 17B is a diagram illustrating disposition of pixels in connection with the display in FIG. 16 according to another embodiment; and
FIG. 17C is a diagram illustrating disposition of pixels in connection with the display in FIG. 16 according to still another embodiment.

### Best Mode for Carrying out the Invention

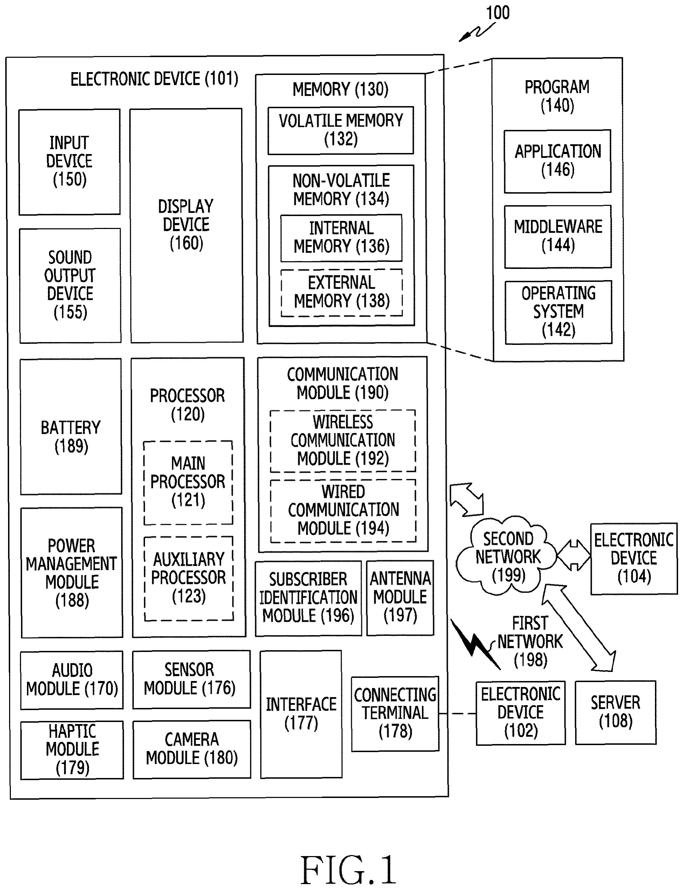

FIG. 1 is a block diagram of an electronic device inside a network environment according to an embodiment.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module(SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, or a keyboard.

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, using subscriber information stored in the subscriber identification module 196.

The antenna module 197 may transmit or receive a signal or power to or from the outside (e.g., the external electronic device) of the electronic device 101. According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

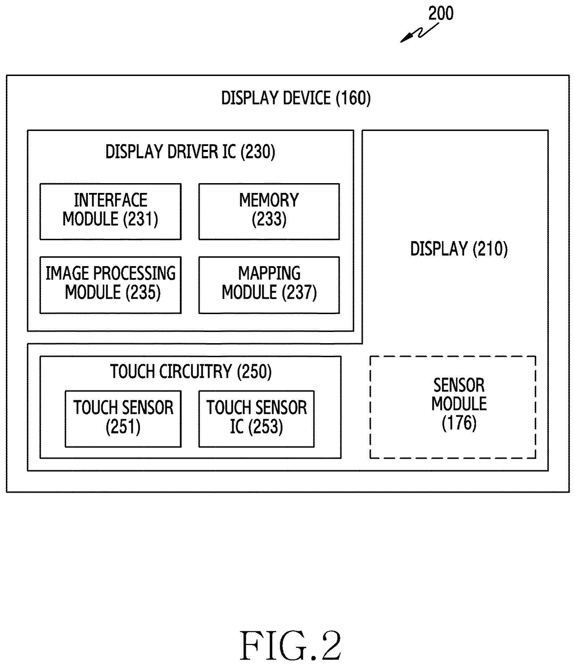

FIG. 2 is a block diagram of a display device according to an embodiment.

Referring to Fig. 2, the display device 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 150 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data pre-processed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display device 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display device 160.

According to an embodiment, the display device 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 150)) of the display device 160. For example, when the sensor module 176 embedded in the display device 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display device 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," " coupled to," " connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

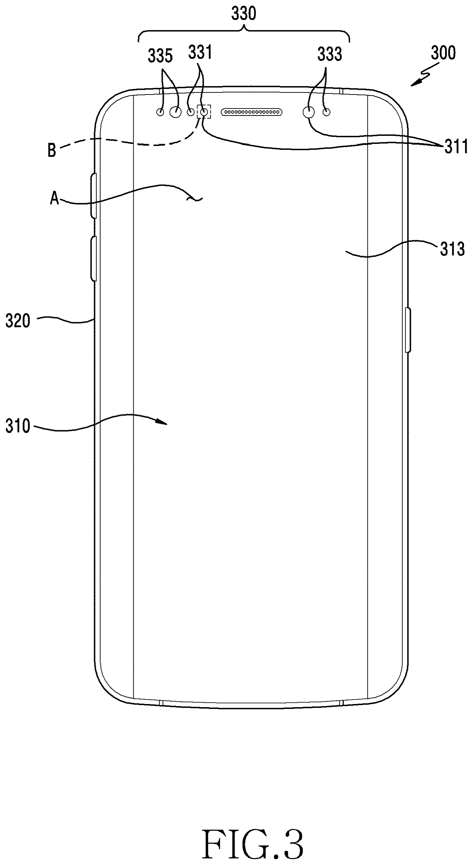

FIG. 3 is a front view of an electronic device according to an embodiment.

Referring to FIG. 3, the electronic device 300 according to various embodiments (for example, electronic device 101 in FIG. 1) may include at least one of a display 310, a front plate 320, or at least one sensor 330. In an embodiment of FIG. 3, the at least one sensor 330 may be disposed below area B of the display 310.

According to an embodiment, the display 310 may be seen through a corresponding portion of the front plate 320. For example, at least a part of the display 310 may be seen through the front plate 320. In various embodiments, the display 310 may have corners formed such that the same has a shape corresponding to that of the front plate 320. This makes it possible to implement the overall front surface of the electronic device 300 as a screen display area of the display 310. In an embodiment, the display 310 may include at least one of a light-emitting diode (LED) display, an organic light-emitting diode (OLED) display, a liquid crystal display (LCD), a microelectromechanical systems (MEMS) display, and an electronic paper display.

According to an embodiment, the display 310 may expose the sensor 330. The sensor 330 may be disposed on the opposite side of the front plate 320 with reference to the display 310. According to various embodiments, the sensor 330 may be disposed on the back surface of the screen display area of the display 310. The sensor 330 may include at least one of a sensor module 331, a camera module 333, and a light-emitting module 335. In some embodiments, at least a part of the sensor 330 may be disposed to penetrate at least a part of the display 310. To this end, the display 310 may include a recess or an opening formed such that the sensor 330 may be inserted therein.

According to an embodiment, the display 310 may include a first area 311 and a second area 313. The first area 311 is a partial area of the screen display area of the display 310, and may correspond to at least one of the sensors 330. A sensor may be disposed beneath the first area 311, and the first area 311, in this connection, may transmit light received from outside the electronic device 300 to the sensor 330, or may transmit light emitted from the sensor 330 to an external object or to an external space. In some embodiments, the second area 313 may be the remaining area of the screen display area other than the first area 311, and may display various kinds of contents (for example, texts, images, videos, icons, or symbols). The second area 313 may include at least one pixel (not illustrated) for displaying colors.

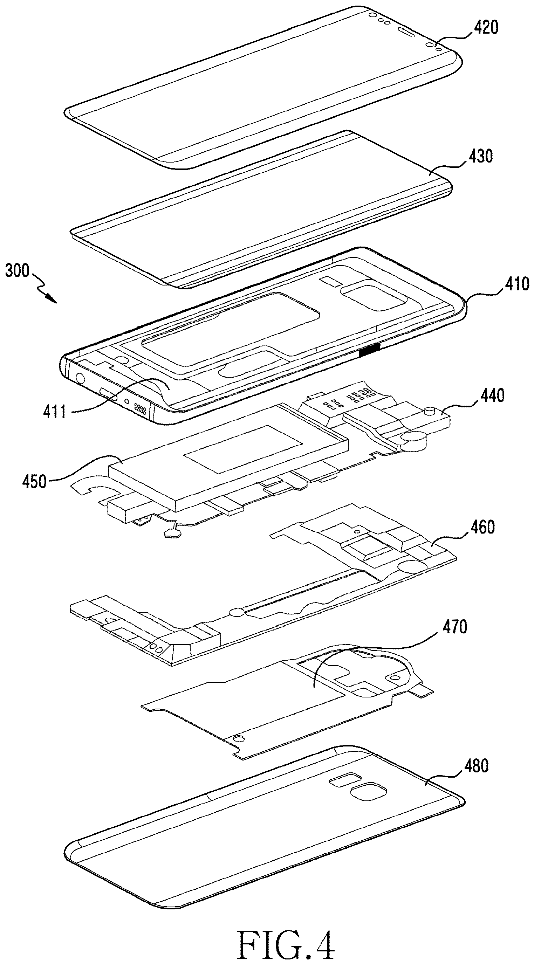

FIG. 4 is an exploded diagram of the electronic device in FIG. 3 according to an embodiment.

Referring to FIG. 4, the electronic device 300 may include a side bezel structure 410, a first support member (for example, bracket), a front plate 420, a display 430, a printed circuit board 440, a battery 450, a second support member 460 (for example, rear case), an antenna 470, and a rear plate 480. In some embodiments, at least one (for example, first support member 411 or second support member 460) of the components of the electronic device 300 may be omitted, or the same may further include another component. At least one of the components of the electronic device 300 may be identical or similar to at least one of the components of the electronic device 100 in FIG. 1 or FIG. 2, and repeated descriptions thereof will be omitted herein.

The first support member 411 may be disposed inside the electronic device 300 and connected to the side bezel structure 410, or may be formed integrally with the side bezel structure 410. The first support member 411 may be made of a metallic material and/or a nonmetallic material (for example, polymer), for example. The display 430 may be coupled to a surface of the first support member 411, and the printed circuit board 440 may be coupled to another surface thereof. A processor, a memory, and/or an interface may be mounted on the printed circuit board 440. The processor may include at least one of a central processing device, an application processor, a graphic processing device, an image signal processor, a sensor hub processor, and a communication processor, for example. The memory may include a volatile memory or a nonvolatile memory, for example. The interface may include a high definition multimedia interface (HDMI), a universal serial bus (USB) interface, an SD card interface, and/or an audio interface, for example. The interface may connect the electronic device 300 to an external electronic device electrically or physically, for example, and may include a USB connector, an SD card/MMC connector, or an audio connector.

The battery 450 is a device for supplying power to at least one component of the electronic device 300, and may include a primary battery that is not rechargeable, a secondary battery that is rechargeable, or a fuel cell, for example. At least a part of the battery 450 may be disposed on substantially the same plane with the printed circuit board 440, for example. The battery 450 may be disposed inside the electronic device 300 integrally with the electronic device 300, or may be disposed such that the same can be attached to/detached from the electronic device 300.

The antenna 470 may be disposed between the rear plate 480 and the battery 450. The antenna 470 may include a near-field communication (NFC) antenna, a wireless charging antenna, and/or a magnetic secure transmission (MST) antenna, for example. The antenna 470 may conduct short-range communication with an external device, for example, or may wirelessly transmit/receive power necessary for charging. In various embodiments, an antenna structure may be formed by a part of the side bezel structure 410 and/or the first support member 411 or by a combination thereof.

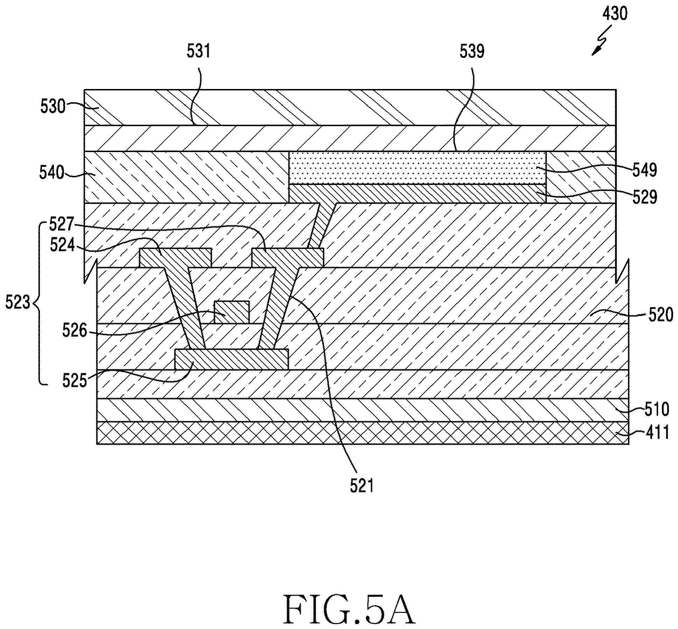

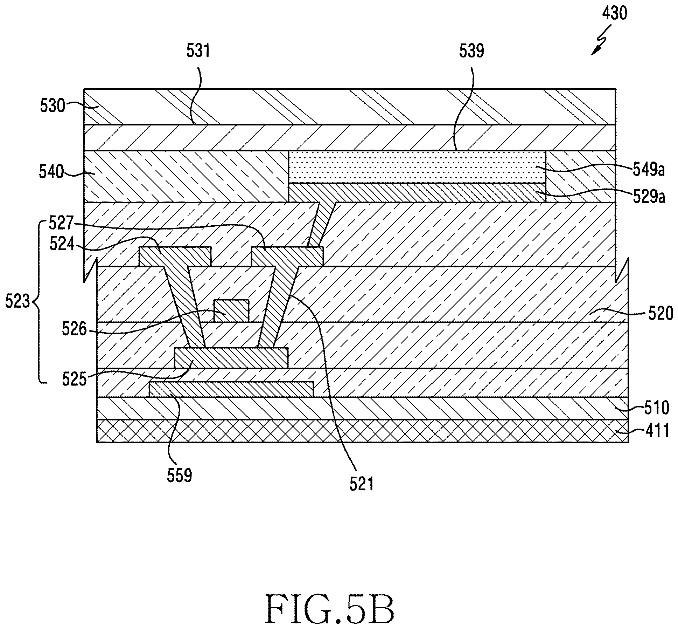

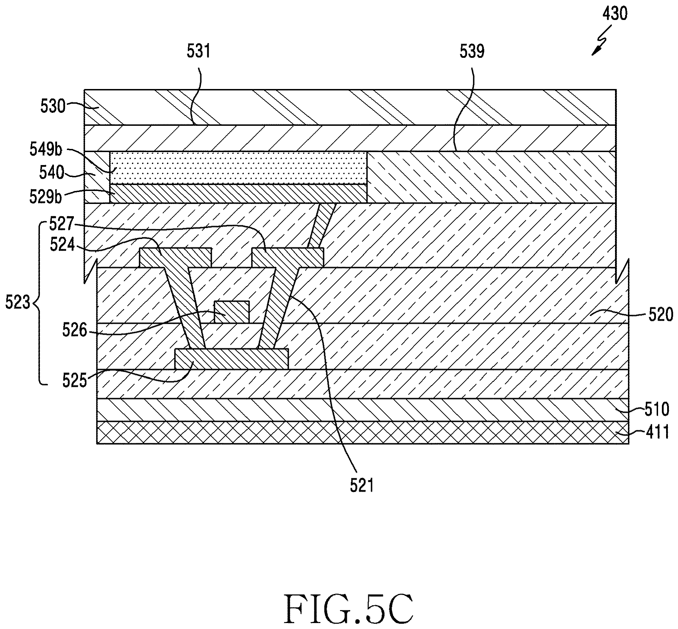

FIG. 5A is a sectional view of the display in FIG. 4 according to an embodiment regarding area A of Figure 3, FIG. 5B is a sectional view of the display in FIG. 4 according to an embodiment regarding area B of Figure 3, and FIG. 5C is a sectional view of the display in FIG. 4 according to still another embodiment. FIG. 5A is a sectional view regarding area A of the display illustrated in FIG. 3, and FIG. 5B and FIG. 5C are sectional views regarding area B of the display illustrated in FIG. 3.

Referring to FIG. 5A, the display 430 may include at least one of a protective member 510, a first substrate 520, a second substrate 530, and a pixel layer 540. As another example, the display 430 may include no protective member 510.

The protective member 510 may be disposed between the first support member 411 and the first substrate 520. The protective member 510 may contact the first support member 411. This may enable the protective member 510 to protect the first substrate 520. In various embodiments, the protective member 510 may include at least one of a polyethylene terephthalate (PET) material and a polyimide (PI) material.

The first substrate 520 may be stacked on the protective member 510 or on the first support member 411. The first substrate 520 may contact one of the protective member 510 or the first support member 411. In various embodiments, the first substrate 520 may include at least one of plastic, glass, and PI. The first substrate 520 may include a first driving wire 521. The first driving wire 521 may extend inside the first substrate 520 or extend along the outer surface of the first substrate 520. In various embodiments, the first driving wire 521 may be made of a metallic material including at least one of Al, Si, Li, Ca, and Mg.

The first driving wire 521 may include at least one switch 523 and at least one anode electrode 529. The at least one switch 523 may be a thin-film transistor (TFT). The at least one switch 523 may include at least one of a source electrode 524, a semiconductor element 525, a gate electrode 526, and a drain electrode 527. The source electrode 524 may supply electrons. The semiconductor element 525 may provide an electrical path between the source electrode 524 and the drain electrode 527. The gate electrode 526 may switch the semiconductor element 525 so as to activate or deactivate the semiconductor element 525. If the semiconductor element 525 is activated by the gate electrode 526, the semiconductor element 525 may move electrons from the source electrode 524 to the drain electrode 527. The drain electrode 527 may release electrons supplied from the source electrode 524. The anode electrode 529 may be connected to the drain electrode 527. The anode electrode 529 may be exposed to a surface of the first substrate 520 facing the second substrate 530. The anode electrode 529 may release electrons supplied from the drain electrode 527.

The second substrate 530 may be stacked on the first substrate 520. The second substrate 530 may contact the first substrate 520. In various embodiments, the second substrate 530 may include at least one of plastic, glass, and PI. The second substrate 530 may include a second driving wire 531. The second driving wire 531 may extend inside the second substrate 530 or extend along the outer surface of the second substrate 530. In various embodiments, the second driving wire 531 may include at least one of indium tin oxide (ITO) and antimony tin oxide (ATO).

The second driving wire 531 may include at least one cathode electrode 539. The cathode electrode 539 may be exposed to a surface of the second substrate 530 facing the first substrate 520. The cathode electrode 539 may be disposed on the second electrode 530 so as to correspond to the anode electrode 529 of the first substrate 520. The cathode electrode 539 may provide holes while facing the anode electrode 529.

The pixel layer 540 may be disposed between the first substrate 520 and the second substrate 530. According to various embodiments, the pixel layer 540 may include at least one of plastic, glass, and PI. The pixel layer 540 may include at least one pixel 549. The at least one pixel 549 may be disposed between the anode electrode 529 of the first substrate 520 and the cathode electrode 539 of the second substrate 530. If electrons are supplied through the anode electrode 529 of the first substrate 520, the electrons from the anode electrode 529 and holes from the cathode electrode 539 may be coupled at the at least one pixel 549. As a result, the at least one pixel 549 may produce extended energy, and the at least one pixel 549 may produce light based on the extended energy. The at least one pixel 549 may produce light having a predetermined color. To this end, the at least one pixel 549 may be made of an organic light-emitting material.

Referring to FIG. 5B, the display 430 may further include an opaque member 559. Disposition of the anode electrode 529a and the pixel 549a may include an identical or similar structure to the anode electrode 529 and the pixel 549 in FIG. 5A. The same descriptions as in FIG. 5A will be omitted herein.

According to various embodiments, the opaque member 559 may prevent diffraction of light emitted from the sensor (for example, sensor 330 in FIG. 3) disposed beneath area B of the display 430 illustrated in FIG. 3, or light delivered to the sensor. Light emitted from the sensor 330 or light delivered to the sensor 330 may diffract through a gap formed between the source electrode 524, the semiconductor element 525, the gate electrode 526, and the drain electrode 527, which form a switch 523 (for example, TFT). The sensor 330 may obtain an image including signal interference or a diffraction pattern, resulting from the diffraction of light. In order to prevent distortion of the image or signal due to the diffraction of light, the opaque member 559 may be disposed on the first substrate 520 corresponding to the switch 523, in the area in which the sensor 330 is disposed.

Referring to FIG. 5C, the anode electrode 529b of the display 430 may be disposed to overlap the switch 523. For example, when the display 430 is seen from above, the source electrode 524, the semiconductor element 525, the gate electrode 526, and the drain electrode 527, which constitute the switch 523, may be covered by the anode electrode 529b.

According to various embodiments, light emitted from the sensor disposed beneath area B of the display 430 illustrated in FIG. 3 or light received by the sensor may be blocked by the anode electrode 529b. The anode electrode 529b may include an opaque conductor material. For example, the anode electrode 529b may include a material which has conductivity as in the case of gold or copper, and which does not transmit light. The anode electrode 529b may prevent an diffraction of light resulting from the interval (or gap) between the components constituting the switch 523. For example, the anode electrode 529b may prevent light introduced from the outside to the sensor from propagating to the elements constituting the switch 523. As another example, when light emitted from the sensor is delivered to the anode electrode 529b through the interval (or gap) between the elements constituting the switch 523, the anode electrode 529b may not transmit the delivered light, thereby preventing the user from seeing a diffraction pattern resulting from the diffraction of light.

According to various embodiments, the pixel 549b may be disposed on the anode electrode 529b, and light emitted from the pixel 549b may pass through the second substrate 530 such that the user can see the same.

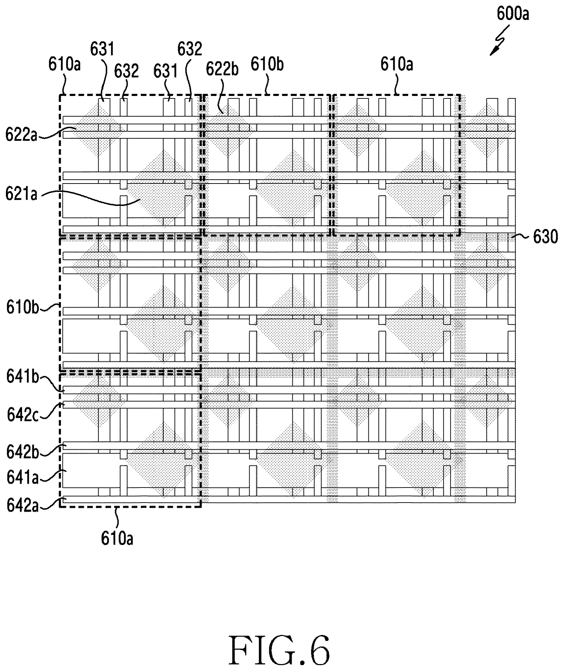

FIG. 6 is a diagram illustrating wires and conductive patterns of a display in connection with area A in FIG. 3 according to an embodiment.

Referring to FIG. 6, the display 600a may include pixels 610a and 610b including an organic light-emitting material, multiple conductive patterns 631, 632, 641a, 641b, 642a, 642b, and 642c, and multiple nonconductive patterns 630. The organic light-emitting material included in the pixels 610a and 610b may be connected to electrodes (for example, anode 529 and cathode 539 of FIG. 5A) via multiple conductive patterns 631, 632, 641a, 641b, 642a, 642b, and 642c.

The pixels 610a and 610b may be formed by multiple subpixels including at least one organic light-emitting materials 621a, 622a, and 622b exhibiting respective colors. The pixels 610a and 610b may be distinguished by nonconductive patterns 630 (for example, pixel define layers (PDL)). The nonconductive patterns 630 may distinguish (or separate) respective pixels 610a and 610b in the same shape, in area A illustrated in FIG. 3. According to various embodiments, the nonconductive patterns 630 may distinguish (or separate) subpixels included in respective pixels 610a and 610b. In area A illustrated in FIG. 3, the nonconductive patterns 630 may define regions such that respective subpixels have the same shape. For example, organic light-emitting materials may be disposed at the pixels 610a and 610b in a regularized manner at a predetermined interval. An anode electrode (for example, anode electrode 529 in FIG. 5) may be disposed beneath the pixels 610a and 610b such that the pixels 610a and 610b are electrically connected to the anode electrode 529. The anode electrode or cathode electrode (not illustrated) may be electrically connected to multiple first conductive patterns 631 and 632 and second conductive patterns 641a, 641b, 642a, 642b, and 642c. The first conductive patterns 631 and 632 and the second conductive patterns 641a, 641b, 642a, and 642b may include driving wires (for example, first driving wire 521 and second driving wire 531 in FIG. 5), a thin-film transistor (TFT) (for example, switch 523 in FIG. 5), an anode electrode, a touch pattern, or an EMR layer.

According to an embodiment, the pixels may include a first pixel 610a and a second pixel 610b. The first pixel 610a may include a first organic light-emitting material 621a and a second organic light-emitting material 622a emitting a color different from that of the first organic light-emitting material 621a. The second pixel 610b may include a first organic light-emitting material 621a and a third organic light-emitting material 622b emitting a color different from the colors emitted by the first organic light-emitting material 621a and the second organic light-emitting material 622a. For example, the first organic light-emitting material 621a may emit light in a green wavelength band, and the second organic light-emitting material 622a may emit light in a red wavelength band. The third organic light-emitting material 622b may emit light in a blue wavelength band. According to another embodiment, the display 600a may include pixels formed to emit four colors (for example, green, red, blue, and white), and in this case, the brightness of light may be adjusted by the organic light-emitting material emitting light in the white wavelength band.

According to an embodiment, multiple first conductive patterns 631 and 632 and second conductive patterns 641a, 641b, 642a, 642b, and 642c may be identically (or uniformly) disposed with respect to each pixel unit.

According to an embodiment, the first conductive patterns 631 and 632 may be disposed on the first substrate (for example, first substrate 520 in FIG. 5A) along a first direction, and may be patterned along the first direction. The first conductive patterns 631 and 632 may be disposed at a predetermined interval from each other, or may be disposed such that multiple patterns having a predetermined interval are periodically repeated. The second conductive patterns 641a, 641b, 642a, 642b, and 642c may be disposed on the first substrate 520 along a second direction perpendicular to the first direction. The first conductive patterns 631 and 632 and the second conductive patterns 641a, 641b, 642a, 642b, and 642c may be distinguished as conductive patterns disposed on a touch panel, or conductive patterns electrically connected to pixels. The conductive patterns may be disposed constantly with regard to each other according to the characteristics of respective conductive patterns. For example, the conductive patterns may include first conductive patterns 631 and second conductive patterns 642a, 642b, and 642c, which are electrically connected to multiple organic light-emitting materials 621a, 622a, and 622b included in a first pixel 610a or second pixel 610b. The first conductive patterns 631 electrically connected to the multiple organic light-emitting materials 621a, 622a, and 622b may be disposed at a predetermined interval from each other, and the second conductive patterns 642a, 642b, and 642c electrically connected to the multiple organic light-emitting materials 621a, 622a, and 622b may be disposed at a predetermined interval from each other. The conductive patterns may include first conductive patterns 632 and second conductive patterns 641a, which form touch patterns. Respective first conductive patterns 632 may be disposed at the same interval from each other, and respective second conductive patterns 641a may be disposed at the same interval from each other.

Respective first conductive patterns 631 and 632 may be disposed to be spaced apart from each other, and respective second conductive patterns 641a, 641b, 642a, 642b, and 642c may also be disposed to be spaced apart from each other. For example, respective first conductive patterns 631 and 632 may be disposed to be parallel with each other, and respective second conductive patterns 641a, 641b, 642a, 642b, and 642c may be disposed to be parallel with each other. Among the conductive patterns, patterns having the same function may be disposed at the same interval in parallel with each other. Accordingly, the conductive patterns may be formed as repeated regularized patterns. For example, in connection with area A illustrated in FIG. 3, the display 600a may include multiple pixels 610a and 610b disposed uniformly at the same interval, and multiple first conductive patterns 631 and 632 and second conductive patterns 641a, 641b, 642a, 642b, and 642c, which are disposed with regularity. Light may pass through the empty space between the conductive patterns resulting from the conductive patterns disposed on the display 600a at a periodic interval. In area A in FIG. 3, light emitted from the sensor or light-emitting element disposed beneath the display 600a, or light received by the sensor or the light-emitting element may be diffracted due to the empty space between the conductive patterns that form slits. Alternatively, the empty space between the conductive patterns that form slits may form a diffraction pattern in the image displayed through the display 600a, or may distort data measured by the sensor. For example, an image taken by a camera may have a diffraction pattern around the light source, due to the diffraction of light, and light emitted from the sensor may have noise occurring near the light path, when transmitted to the outside, thereby making it difficult to acquire an accurate measurement value.

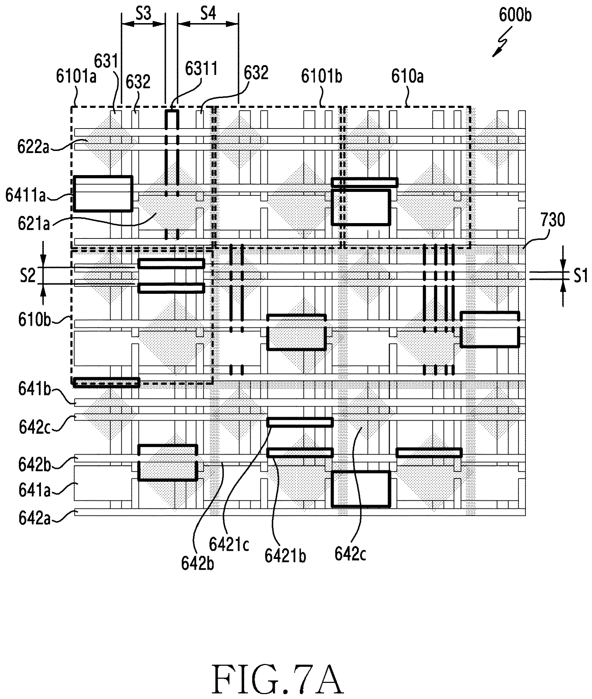

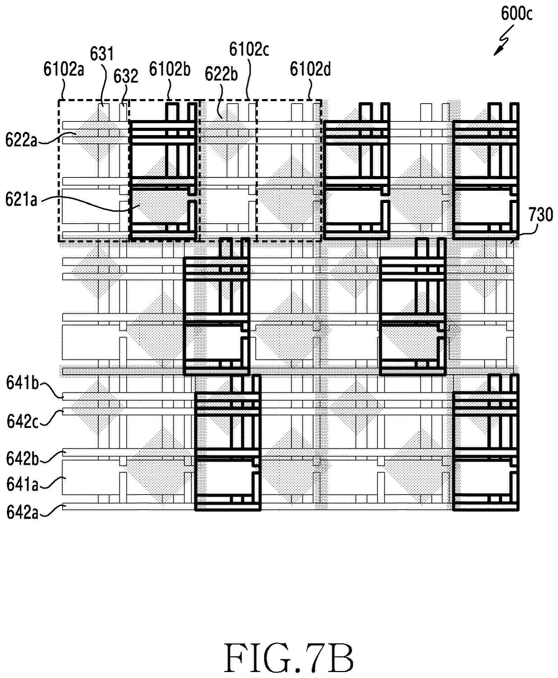

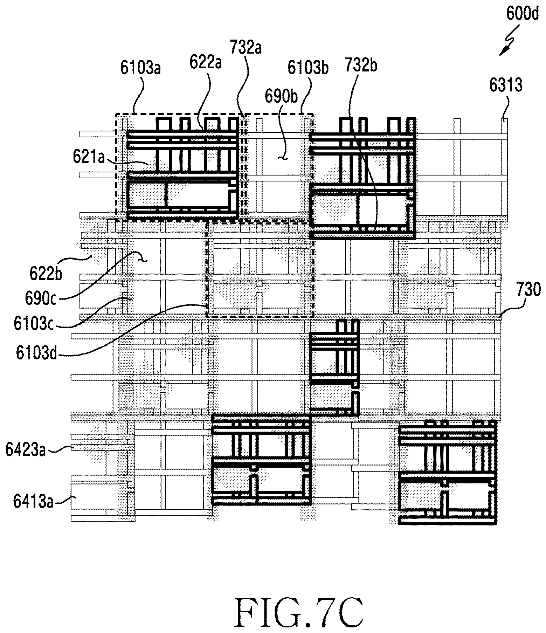

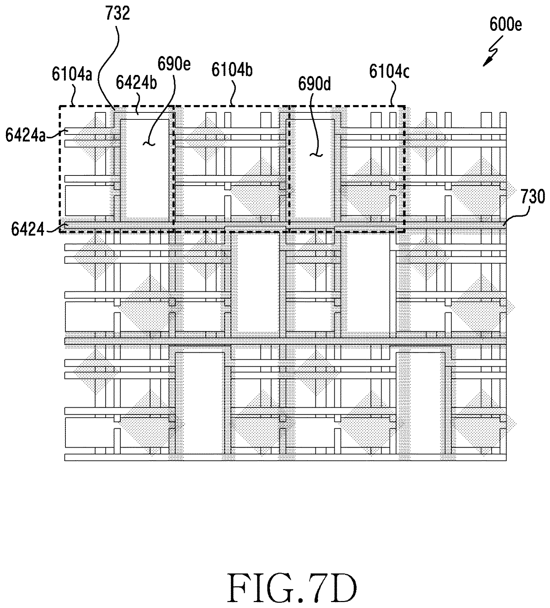

FIG. 7A is a diagram illustrating wires and conductive patterns of a display in connection with area B in FIG. 3 according to one embodiment, FIG. 7B is a diagram illustrating wires and conductive patterns of a display in connection with area B in FIG. 3 according to another embodiment, FIG. 7C is a diagram illustrating wires and conductive patterns of a display in connection with area B in FIG. 3 according to another embodiment, and FIG. 7D is a diagram illustrating wires and conductive patterns of a display in connection with area B in FIG. 3 according to another embodiment.

The wires and conductive patterns in FIGS. 7A-7D have non-regular spacing to reduce noise from refraction of light generated by sensors under the pixels, and refraction of light received by the sensors.

FIG. 7A, FIG. 7B, FIG. 7C, and FIG. 7D illustrate various embodiments for adjusting different intervals between conductive patterns in connection with the area B of the display, which corresponds to disposition of a sensor. In order to prevent distortion of light emitted from the light source included in the sensor, or light received by the sensor, the conductive patterns may be disposed in a non-regularized manner after adjusting the interval between the same.

Referring to FIG. 7A, the pixels 6101a and 6101b included in the display 600b may be distinguished (or separated) by nonconductive patterns 730. The nonconductive patterns 730 may distinguish (or separate) respective pixels 6101a and 6101b in the same shape in the area B. According to various embodiments, the nonconductive patterns 730 may distinguish subpixels included in respective pixels 6101a and 6101b. The nonconductive patterns 730 may define regions such that, in the area B, respective subpixels have the same shape. According to various embodiments, the nonconductive patterns 730 may be formed in a non-regularized manner, and may also be formed in a non-regularized manner in the case of FIG. 7B, FIG. 7C, and FIG. 7D (described later).

According to an embodiment, in order to maintain a constant color impression by the light emitted from light sources (for example, organic light-emitting materials 621a, 622a, and 622b in FIG. 6), and in order to maintain a uniform quality of the screen displayed by the display 600b, the light sources (for example, 621a, 622a, and 622b) included in the pixels (for example, 6101a and 6101b) may be disposed in a predetermined manner. In order to prevent diffraction occurring when light emitted by the sensor disposed beneath the area B of the display 600b or light received by the sensor passes through the display 600b, or in order to counterbalance light diffracted by the display 600b, the interval between conductive patterns or electrodes disposed on the display 600b may be formed in a non-regularized manner. If the interval between the conductive patterns or the electrodes through which light passes is formed in a non-regularized manner, various types of diffraction patterns may be formed, and rays of light diffracted after passing through respective intervals may counterbalance each other.

In an embodiment, the position of some components of the display 600b may be modified as compared to the display 600a. In the case of the first pixel 6101a, one 6311 of first conductive patterns constituting the first pixel 6101a, and one 6411a of second conductive patterns constituting the same, may be offset or displaced as compared to Figure 6. In some embodiments a part of first conductive patterns or second conductive patterns can be parallel with each other and another part curves and overlaps each other. For example, in area A in FIG. 3, one 6311 of the first conductive patterns constituting the first pixel 6101a may be disposed at a predetermined interval from another first conductive pattern 631. However, in area B in FIG. 3, the interval S3 between one 6311 of first conductive patterns constituting the first pixel 6101a and another first conductive pattern 631 may differ from the interval S4 between one 6311 of the first conductive patterns in the second pixel 6101b and another first conductive pattern 631. In area B in FIG. 3, one 6411 of second conductive patterns included in the first pixel 6101a may have a part positioned differently from that in area A in FIG. 3.

According to various embodiments, in the case of the second pixel 610b formed in the direction in which the first conductive pattern 631 of the first pixel 6101a extends, most second conductive patterns may be formed at the same interval S1 as in area A in FIG. 3, but some second conductive patterns may be formed at a larger interval S2 than the interval S1.

According to various embodiments, the first conductive patterns 631 and 632 or the second conductive patterns 641a, 641b, 642a, 642b, and 642c may displaced to areas 6311, 6411a, 6421b, and 6421c. By displacing the position of wires, among the components of the pixel, as desired, conductive patterns disposed on at least some pixels of area B in FIG. 3 may be formed in a non-regularized manner. Intervals formed by first conductive patterns 631 and 632 or second conductive patterns 642a, 642b, and 642c, which are deformed in various positions, may be wider or narrower in some sections. According to various embodiments, by means of the position or interval of various slits formed by the deformed conductive patterns, the sensor module disposed so as to correspond to area B of the display 600b may be less influenced by noise resulting from diffraction of light.

Referring to FIG. 7B, in area B in FIG. 3, the position of the first subpixel 6102a or the second subpixel 6102b of some pixels constituting the display 600c may be different. For example, the first subpixel 6102a may be disposed in the same position, and elements of the second subpixel 6102b may be disposed closer to pixel 6102a in the horizontal direction as compared to Fig. 7A or 6. For example, first conductive patterns 631 and 632 and second conductive patterns 641a, 641b, 642a, 642b, and 642c, which form the second subpixel 6102b, may be formed away from the first subpixel 6102a. First conductive patterns 631 and 632 and second conductive patterns 641a, 641b, 642a, 642b, and 642c, which constitute the second subpixel 6102b, may be displaced, thereby overlapping the position of wires positioned in an adjacent first subpixel 6102c, or reducing the size of the adjacent first subpixel 6102c. If the size of the adjacent first subpixel 6102c is different, the size of the adjacent first subpixel 6102c may differ from the size of an adjacent second subpixel 6102d. According to various embodiments, the interval of nonconductive patterns 730 defining the pixel including the first subpixel 6102a and the second subpixel 6102b may differ from the interval of nonconductive patterns 730 defining the pixel including the adjacent first subpixel 6102c and the second subpixel 6102d. As another example, respective subpixels 6102a, 6102b, 6102c, and 6102d may be formed to have different sizes, and nonconductive patterns 730 defining respective subpixels 6102a, 6102b, 6102c, and 6102d may have different intervals. For example, subpixels 6102a and 6102b may be larger than subpixel 6102c.

Referring to FIG. 7C, in area B in FIG. 3, some pixels 6103b and 6103c constituting the display 600d may be removed (or the area under the display at locations 6103b and 6103c may not have pixels), and the position and shape of adjacent pixels may be modified.

According to various embodiments, the shape of the first pixel 6103a may extend in the direction in which the second conductive patterns 6413a and 6424a extend. No second pixel 6103b may be disposed, and an empty space (or pixel void without pixel) 690b may be formed in an area adjacent in the direction in which the second conductive patterns 6413a and 6423a extend from the first pixel 6103a. Similarly, no third pixel 6103c may be disposed, and an empty space 690c (or a space with conductive members, wiring, and no pixel) may be formed in an area adjacent in the direction in which the first conductive pattern 6313 extends from the first pixel 6103a. Empty spaces 690b and 690c having no pixels positioned therein may be formed in various areas of the display 600d with various sizes or shapes. In the empty spaces 690b and 690c having no pixels positioned therein, some conductive patterns 6313 and 6423a may be maintained, and some other conductive patterns 6413a may not be formed. According to various embodiments, disposition of conductive patterns in the empty spaces 690b and 690c may be variously implemented, as long as the function of the display can be maintained.

In various embodiments, the first pixel 6013a and the fourth pixel 6103d, which are maintained, may be formed in different shapes. Due to the first pixel 6013a and the fourth pixel 6103d, which are maintained, the empty spaces 690b and 690c may be formed in various sizes and shapes.

According to various embodiments, the first pixel 6103a, the fourth pixel 6103d, or the empty spaces 690b and 690c may be defined by nonconductive patterns 730. The first pixel 6103a, the fourth pixel 6103d, and the empty spaces 690b and 690c may have different sizes and shapes. The interval between respective nonconductive patterns 730 defining the first pixel 6103a, the fourth pixel 6103d, or the empty spaces 690b and 690c may be different. In area B in FIG. 3, the nonconductive patterns 730 formed on the display 600d may have intervals formed in a non-regularized manner between respective patterns. For example, the nonconductive pattern 732a disposed between the first pixel 6103a and the second pixel 6103b may be disposed at a different interval, unlike other nonconductive patterns 730. As a result, the empty space 690b may be formed to have a size different from the size of another empty space 690c, and the nonconductive patterns 730 may have different shapes. According to various embodiments, some of the pixels formed on the display 600d may not be formed in a non-regularized manner, and the remaining maintained pixels may be formed to have various shapes/sizes. As a result of the size and interval of slits formed by empty spaces having various shapes and patterns having various intervals, the influence of diffraction of light emitted from the light source of the sensor module or light received by the sensor module may be minimized.

Referring to FIG. 7D, some subpixels of multiple pixels of the display 600e may be removed (or absent). The first pixel 6104a may include an empty space 690e in which some subpixels are not formed, and no conductive patterns 6424 may be formed in the empty space 690e. In the case of a wire requiring a conductive pattern, a conductive pattern 6424a formed in an area in which subpixels are maintained may be formed to extend (6424b) along the edge of the empty space 690e.

According to various embodiments, components constituting the second pixel 6104b may be maintained, and some subpixels may not be formed in the third pixel 6104c, and an empty space 690d may be formed therein. According to various embodiments, the display 600e may include a space in which no subpixels are formed, in a non-regularized manner. The display 600e may have empty spaces formed at different intervals between the same. Due to various intervals between the empty spaces, the influence of diffraction of light emitted from the light source of the sensor module or light received by the sensor module may be minimized. According to various embodiments, the display 600e may have an additional nonconductive pattern 732 that distinguishes empty spaces 690d and 690e. Even if the nonconductive pattern 730 is disposed in a regularized manner so as to distinguish pixels, the nonconductive pattern 732 formed in a non-regularized manner so as to distinguish empty spaces 690d and 690e may be formed irregularly. The nonconductive pattern 732 disposed in a non-regularized manner, the conductive pattern 6424b, and the like may reduce the influence of diffraction of light emitted from the display.

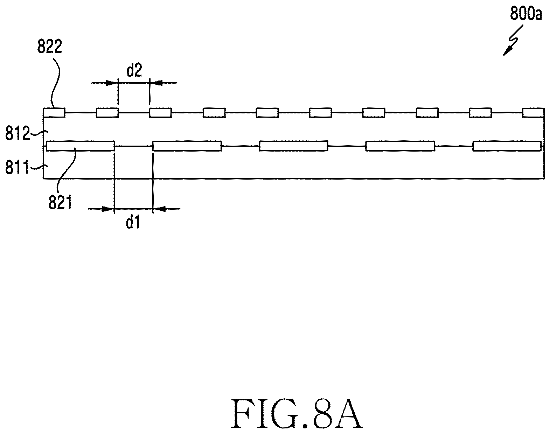

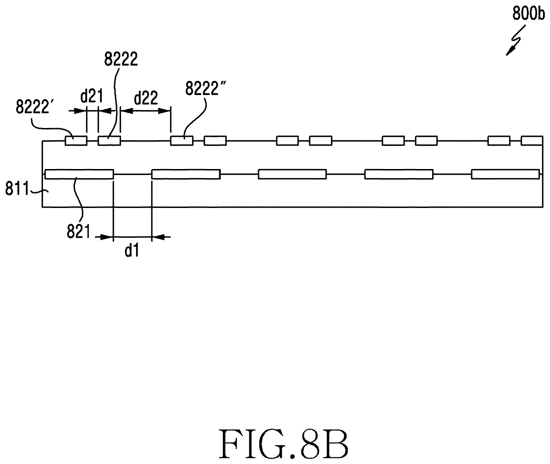

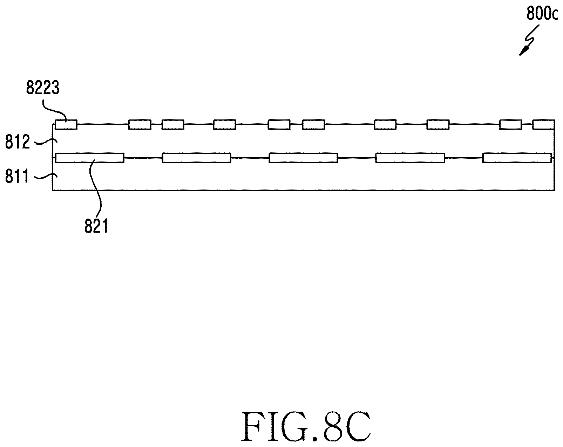

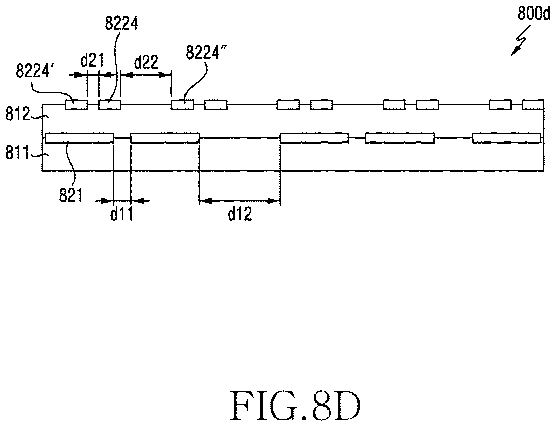

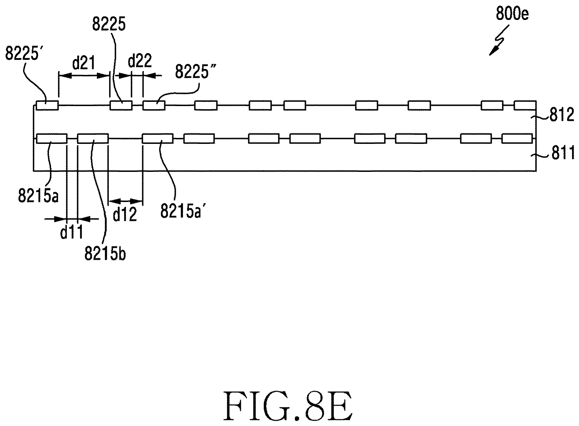

FIG. 8A is a sectional view of a display in connection with area A in FIG. 3 according to an embodiment. FIG. 8B is a sectional view of a display in connection with area B in FIG. 3 according to an embodiment. FIG. 8C is a sectional view of a display in connection with area B in FIG. 3 according to another embodiment. FIG. 8D is a sectional view of a display in connection with area B in FIG. 3 according to another embodiment. FIG. 8E is a sectional view of a display in connection with area B in FIG. 3 according to another embodiments.

FIG. 8A schematically illustrates a section of the display 800a corresponding to area A in FIG. 3. The display 800a may be formed to have multiple layers, and multiple patterns may be formed on respective layers.

According to various embodiments, the display 800a may include a first layer 811 and a second layer 812 disposed on the first layer 811. The first layer 811 or the second layer 812 may be a substrate or a display panel substrate, on which a touch panel is disposed. The first layer 811 may have a first pattern 821 formed thereon. The first pattern 821 may include at least one of the first conductive patterns 631 and 632 in FIG. 6, the second conductive patterns 641a, 641b, 642a, 642b, and 642c in FIG. 6, and a nonconductive pattern (or PDL) that defines a pixel. The first pattern 821 may include at least one of a touch panel, a first driving wire (for example, first driving wire 521 in FIG. 5), a second driving wire (for example, second driving wire 531 in FIG. 5), and a PDL.

The second layer 812 may have a second pattern 822 formed thereon. The second pattern 822 may include at least one of the first conductive patterns 632 and 632 in FIG. 6, the second conductive patterns 641a, 641b, 642a, 642b, and 642c in FIG. 6, and a nonconductive pattern. The second pattern 822 may include at least one of a touch panel, a first driving wire (for example, first driving wire 521 in FIG. 5), a second driving wire (for example, second driving wire 531 in FIG. 5), and a PDL.

According to various embodiments, on the first layer 811, the first pattern 821 may be disposed at an interval d1 from an adjacent first pattern. The first patterns 821 may be disposed at a constant interval d1 from each other. On the second layer 812, the second pattern 822 may be disposed at an interval d2 from an adjacent second pattern. The second patterns 822 may be disposed at a constant interval d2 from each other. The first patterns 821 and the second patterns 822, which are disposed at predetermined intervals, may prevent transmission of light, and light passing through the intervals d1 and d2 formed by respective patterns may undergo diffraction.

Referring to FIG. 8B, the display 800b may include second patterns 8222, 8222', and 8222" disposed at different intervals. In the embodiment described with reference to FIG. 8B, the display 800b may be substantially identical or similar to the display 800a in FIG. 8A, except for the disposition of the second patterns 8222, 8222', and 8222", and repeated descriptions thereof will be omitted herein.

According to an embodiment, the interval d21 between a second pattern 8222 and an adjacent second pattern 8222' on the second layer 812 may differ from the interval d22 between the second pattern 8222 and another adjacent second pattern 8222". The first patterns 821 may be disposed on the first layer 311 at a predetermined interval d1.

Based thereon, the first patterns 821 are disposed at a constant interval d1, and the second patterns 8222, 8222', and 8222" are disposed at various (or varying) intervals d21 and d22, and the intervals between patterns included in the display 800b may accordingly be formed variously. Although light passing through the intervals between respective patterns may diffract, the diffracted light may undergo counterbalancing interference, which may reduce unnecessary diffraction patterns.

Referring to FIG. 8C, the display 8000c may include second patterns 8223 disposed at different intervals. In the embodiment described with reference to FIG. 8C, the display 800c may be substantially identical or similar to the display 800a in FIG. 8A, except for the disposition of the second patterns 8223, and repeated descriptions thereof will be omitted herein.

According to an embodiment, the second patterns 8223 may be disposed at non-regularized intervals. The intervals between the second patterns 8223 may be variously formed such that, even if the first patterns 821 are disposed at a regular interval, the intervals between patterns included in the display 800c may be variously formed. Although light passing through the intervals between respective patterns may diffract, the diffracted light may undergo counterbalancing interference, and this may reduce unnecessary diffraction patterns.

Referring to FIG. 8D, the display 800d may have first patterns 821 and second patterns 8224, 8224', and 8224" disposed at different intervals. In the embodiment described with reference to FIG. 8D, the display 800d may be substantially identical or similar to the display 800a in FIG. 8A, except for the disposition of the first patterns 821 and the second patterns 8224, 8224', and 8224", and repeated descriptions thereof will be omitted herein.

According to an embodiment, on the second layer 812, the interval d21 between a second pattern 8224 and an adjacent second pattern 8224' may differ from the interval d22 between the second pattern 8224 and another adjacent second pattern 8224".

According to an embodiment, on the first layer 811, the first patterns 821 may have different intervals d11 and d12 from adjacent first patterns.

Since the first patterns 821 and the second patterns 8224, 8224', and 8224" are disposed at various intervals d11, d12, d21, and d22, the intervals between patterns included in the display 800d may be variously formed. Although light passing through the intervals between respective patterns may diffract, the diffracted light may undergo counterbalancing interference, and this may prevent occurrence of unnecessary diffraction patterns.

Referring to FIG. 8E, the display 800e may have first patterns 8215a, 8215b, and 8215a' and second patterns 8225, 8225', and 8225" disposed at different intervals. In the embodiment described with reference to FIG. 8E, the display 800e may be substantially identical or similar to the display 800a in FIG. 8A, except for the disposition of the first patterns 8215a, 8215a', and 8215b, and the second patterns 8225, 8225', and 8225", and repeated descriptions thereof will be omitted herein.

According to an embodiment, on the second layer 812, the interval d21 between a second pattern 8225 and an adjacent second pattern 8225' may differ from the interval d22 between the second pattern 8225 and another adjacent second pattern 8225". A first pattern may be formed to constitute a pair (for example, 8215a and 8215b). A pair of first patterns 8215a and 8215b which are electrically connected to the same pixel, or which perform the same function, may be disposed at an interval d11 from each other. The interval d12 between a first pattern 8215b and another adjacent first pattern 8215a'may differ from the interval d11 between the pair of first patterns 8215a and 8215b.

Since the first patterns 8215a, 8215b, and 8215a' and the second patterns 8225, 8225', and 8225" are disposed at various intervals d11, d12, d21, and d22, the intervals between patterns included in the display 800e may be variously formed. Although light passing through the intervals between respective patterns may diffract, the diffracted light may undergo counterbalancing interference, thereby preventing occurrence of unnecessary diffraction patterns.

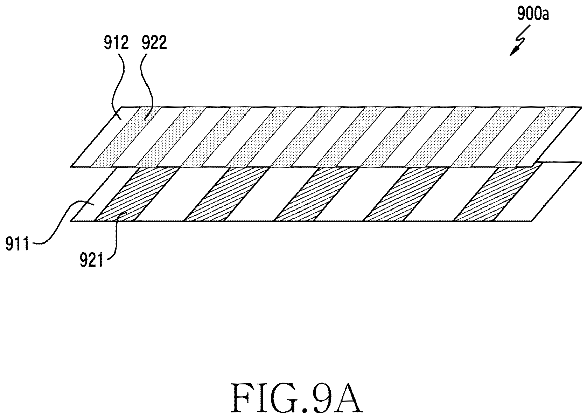

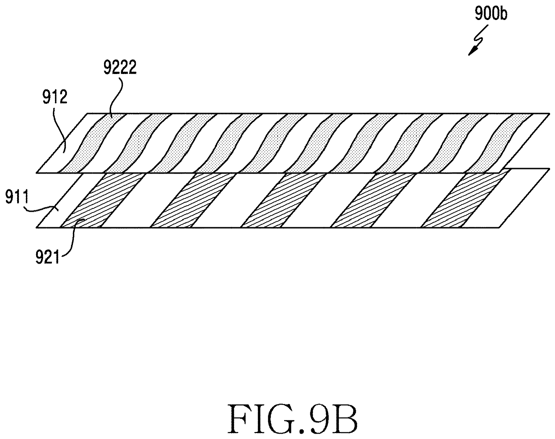

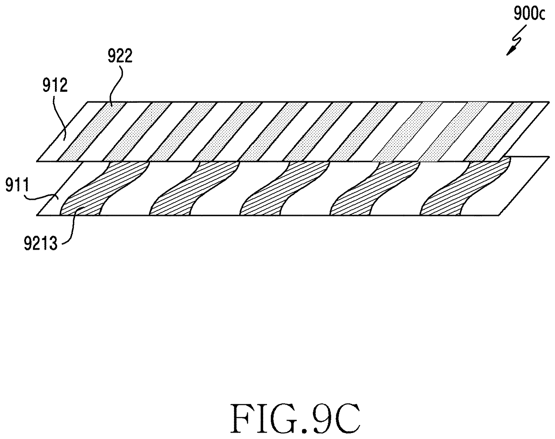

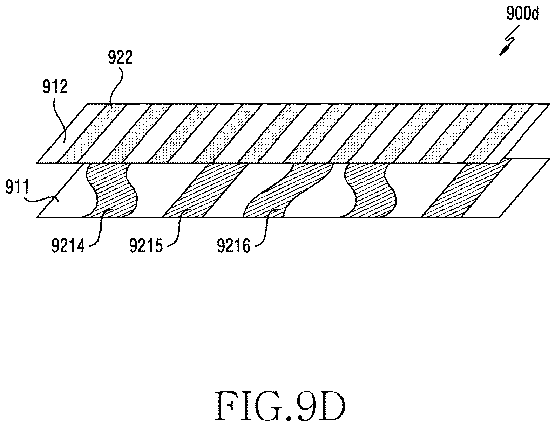

FIG. 9A is a diagram illustrating wires and patterns included in respective layers of a display in connection with area A in FIG. 3 according to an embodiment. FIG. 9B is a diagram illustrating wires and patterns included in respective layers of a display in connection with area B in FIG. 3 according to an embodiment. FIG. 9C is a diagram illustrating wires and patterns included in respective layers of a display in connection with area B in FIG. 3 according to another embodiments. FIG. 9D is a diagram illustrating wires and patterns included in respective layers of a display in connection with area B in FIG. 3 according to another embodiments.

FIG. 9A schematically illustrates a section of the display 900a corresponding to area A in FIG. 3. The display 900a may be formed to have multiple layers, and multiple patterns may be formed on respective layers.

According to various embodiments, the display 900a may include a first layer 911 and a second layer 912 disposed on the first layer 911. The first layer 911 or the second layer 912 may be a substrate or a display panel substrate, on which a touch panel is disposed. The first layer 911 may have a first pattern 921 formed thereon. The first pattern 921 may include at least one of the first conductive patterns 631 and 632 in FIG. 6, the second conductive patterns 641a, 641b, 642a, 642b, and 642c in FIG. 6, and a nonconductive pattern (PDL) that defines a pixel. The first pattern 921 may include at least one of a touch panel, a first driving wire (for example, first driving wire 521 in FIG. 5), a second driving wire (for example, second driving wire 531 in FIG. 5), and a PDL.

The second layer 912 may have a second pattern 922 formed thereon. The second pattern 922 may include at least one of the first conductive patterns 632 and 632 in FIG. 6, the second conductive patterns 641a, 641b, 642a, 642b, and 642c in FIG. 6, and a nonconductive pattern that defines a pixel. The second pattern 922 may include at least one of a touch panel, a first driving wire (for example, first driving wire 521 in FIG. 5), a second driving wire (for example, second driving wire 531 in FIG. 5), and a PDL.

According to various embodiments, the first pattern 921 may be repeatedly disposed on the first layer 911 in the same shape (or regular intervals). The second pattern 922 may be repeatedly disposed on the second layer 912 in the same shape (or regular intervals). The first pattern 921 and the second pattern 922, which are disposed in predetermined shapes, block transmission of light, and respective patterns form the same interval such that light passing through the display 900a may diffract.

Referring to FIG. 9B, the second pattern 9222 of the display 900b may be formed in a different type from the first pattern 921. Referring to FIG. 9C, the first pattern 9213 of the display 900c may be formed in a different type from the second pattern 922. Referring to FIG. 9D, the first patterns 9214, 9215, and 9216 of the display 900d may be formed in a different type from the second pattern 922, and the first patterns 9214, 9215, and 9216 may be formed in different shapes, respectively.

In the embodiment described with reference to FIG. 9B, FIG. 9C, or FIG. 9D, the display 900b, 900c, or 900d may be substantially identical or similar to the display 900a in FIG. 9A, except for the shape of the first and second patterns, and repeated descriptions thereof will be omitted herein.

According to various embodiments, the first and second patterns included in the display 900b, 900c, or 900d may be formed in various types, and the first and second patterns may have differently formed intervals, as a result of the variously formed patterns. The different intervals formed by respective patterns guarantee that, even if light passing through the display 900b, 900c, or 900d diffracts, the diffracted light may not produce noise caused by diffraction due to counterbalancing interference.

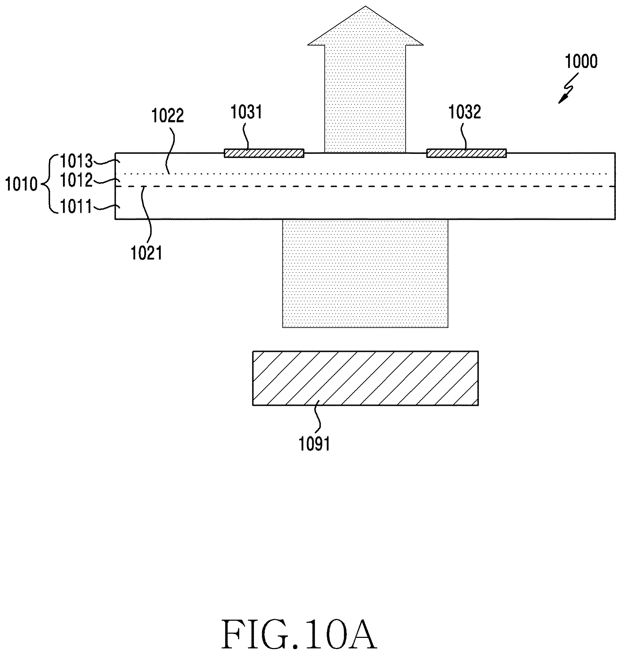

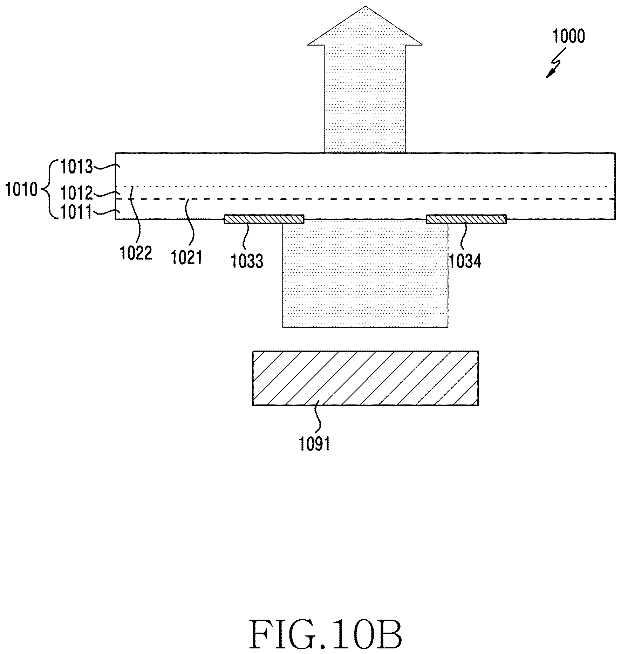

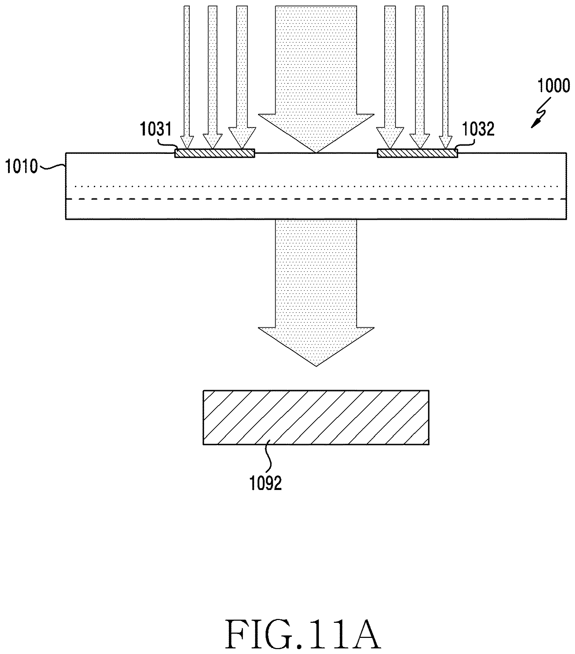

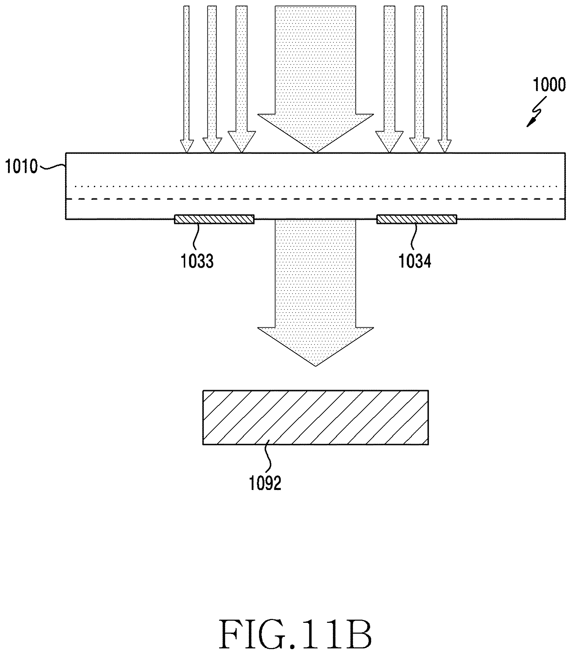

FIG. 10A is a diagram illustrating the path of light emitted from a sensor positioned beneath a display according to an embodiments, and FIG. 10B is a diagram illustrating the path of light emitted from a sensor positioned beneath a display according to another embodiments. FIG. 11A is a diagram illustrating the path of light detected by a sensor positioned beneath a display according to an embodiments, and FIG. 11B is a diagram illustrating the path of light detected by a sensor positioned beneath a display according to another embodiments.

Referring to FIG. 10A, FIG. 10B, FIG. 11A, and FIG. 11B, the electronic device 1000 (for example, electronic device 300 in FIG. 3) may include a display 1010 and a sensor module 1091 or 1092 disposed beneath the display 1010. If light is emitted by the light source included in the sensor module 1091 or 1092 (Figures 10A, 10B), the light may be diffracted, in the process of passing through the display 1010, by the first conductive pattern 1021 formed on the first layer 1011 or by the second conductive pattern 1022 formed on the second layer 1012. If the light emitted by the sensor module 1091 or 1092 produces noise as a result of diffraction, the accuracy of data sensed by the sensor module 1091 or 1092 may degrade. In order to remove or reduce the noise of light emitted by the sensor module 1091 or 1092 or received by the sensor module 1091 or 1092, the display 1010 may include a band rejection filter (BRF) or a notch filter.

Referring to FIG. 10A and FIG. 11A, the BRFs 1031 and 1032 may be positioned on the third layer 1013 disposed above the second layer 1012. The BRFs 1031 and 1032 may be disposed between the display 1010 and a window laminated on the display 1010.

Referring to FIG. 10B and FIG. 11B, the BRFs 1033 and 1034 may be positioned on the first layer 1011 of the display 1010. The BRFs 1033 and 1034 may be disposed between the display 1010 and the sensor module 1091 or 1092.

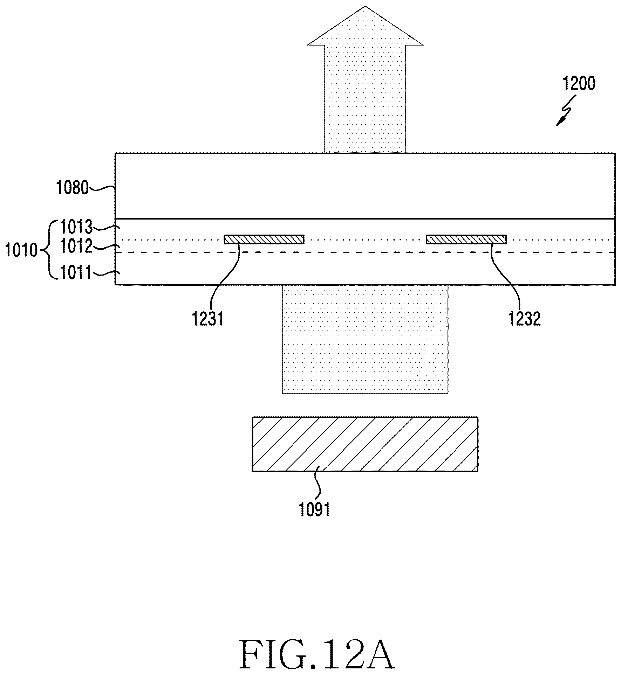

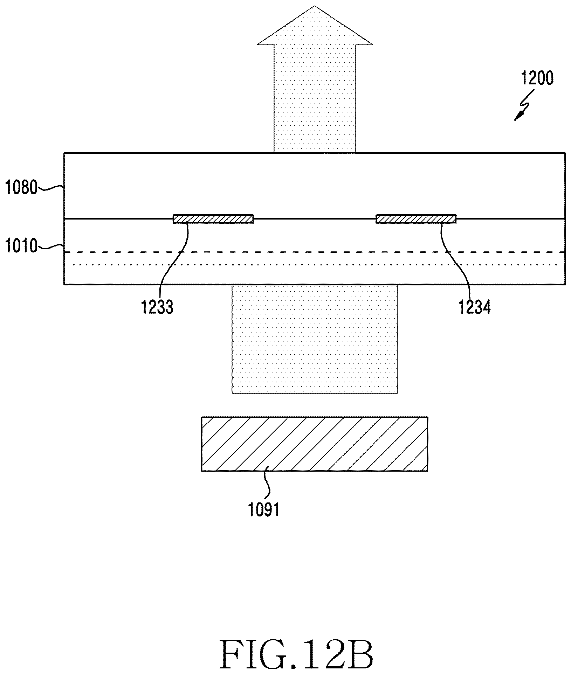

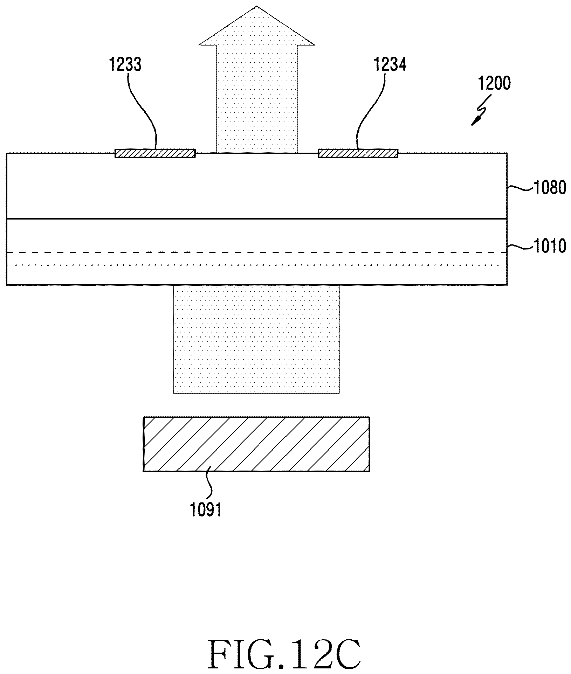

FIG. 12A is a diagram illustrating the position of a mask disposed on an electronic device according to an embodiments, FIG. 12B is a diagram illustrating the position of a mask disposed on an electronic device according to another embodiments, and FIG. 12C is a diagram illustrating the position of a mask disposed on an electronic device according to another embodiments.

Referring to FIG. 12A, FIG. 12B, and FIG. 12C, the electronic device 1200 (for example, electronic device 300 in FIG. 3) may include a display 1010, a transparent plate 1080, and a sensor module 1091. BRFs 1231, 1232, 1233, and 1234 may be disposed on at least one of the display 1010 and the transparent plate 1080, or between the display 1010 and the transparent plate 1080.

Referring to FIG. 12A, BRFs 1231 and 1232 may be disposed on the second layer 1012, among the layers 1011, 1012, and 1013 of the display 1010. The first layer 1011 and the second layer 1012 include conductive patterns, and light may be diffracted by intervals formed by the conductive patterns. Accordingly, BRFs 1231 and 1232 may be disposed on the second layer 1012.

Referring to FIG. 12B, BRFs 1233 and 1234 may be disposed between the display 1010 and the transparent plate 1080. Referring to FIG. 12C, BRFs 1233 and 1234 may be formed on the outermost part of the transparent plate 1080.

According to various embodiments, the BRFs 1231, 1232, 1233, and 1234 may be formed on components of the display 1010, which may diffract light, and this may reduce diffraction of light emitted from the light source of the sensor module 1091.

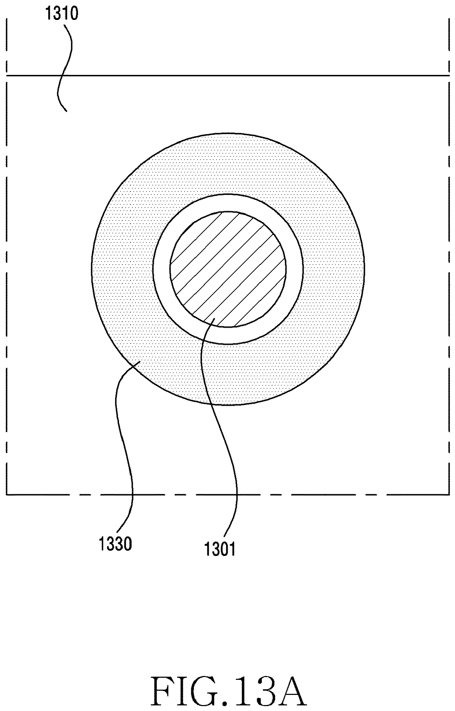

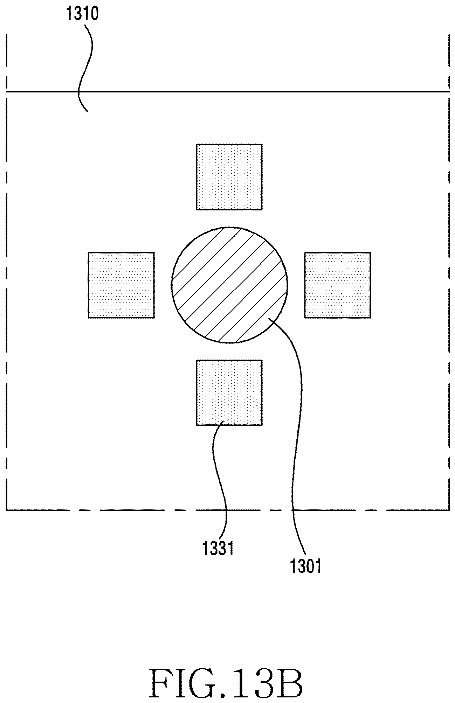

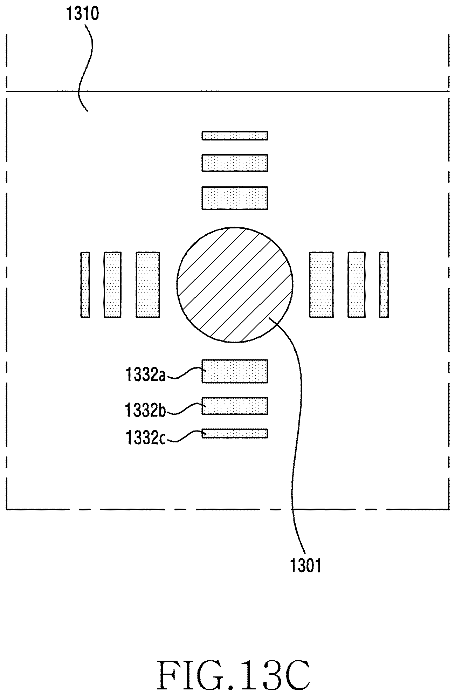

FIG. 13A is a diagram illustrating various shapes of a mask disposed on an electronic device according to an embodiments (for example, electronic device 300 in FIG. 3). FIG. 13B is a diagram illustrating various shapes of a mask disposed on an electronic device according to another embodiments (for example, electronic device 300 in FIG. 3). FIG. 13C is a diagram illustrating various shapes of a mask disposed on an electronic device according to another embodiments (for example, electronic device 300 in FIG. 3).

Referring to FIG. 13A, FIG. 13B, and FIG. 13C, BRFs 1330, 1331, 1332a, 1332b, and 1332c may be formed around a light source 1301 so as to remove diffracted light from the band. Therefore, the BRFs 1330, 1331, 1332a, 1332b, and 1332c may be formed only in an area in which diffracted light is delivered. Various diffraction patterns may be formed depending on the type of the light source 1301 or the shape of factors causing diffraction of light, such as a conductive pattern, and the BRFs 1330, 1331, 1332a, 1332b, and 1332c may be formed in various shapes according to the intensity or type of the diffracted pattern.

Referring to FIG. 13A, the display 1310 may have a BRF 1330 formed around a light source 1301 included in a sensor module (for example, sensor module 1091 in FIG. 12A, FIG. 12B, or FIG. 12C). The BRF 1330 may be formed in a circular shape or in a polygonal shape.

Referring to FIG. 13B, the display 1310 may have a BRF 1331 formed thereon in a shape corresponding to the diffraction pattern of light emitted from the light source 1301 of the sensor module.

Referring to FIG. 13C, the display 1310 may have BRFs 1332a, 1332b, and 1332c formed thereon in a shape corresponding to the diffraction pattern of light emitted from the light source 1301 of the sensor module. According to various embodiments, the BRFs may include a first filter 1332a, a second filter 1332b, and a third filter 1332c, which become narrower in proportion to the distance from the light source 1301. The BRFs 1332a, 1332b, and 1332c may be formed as various numbers of filters and/or filters having various thicknesses, according to the type of diffraction patterns formed by the light source 1301.

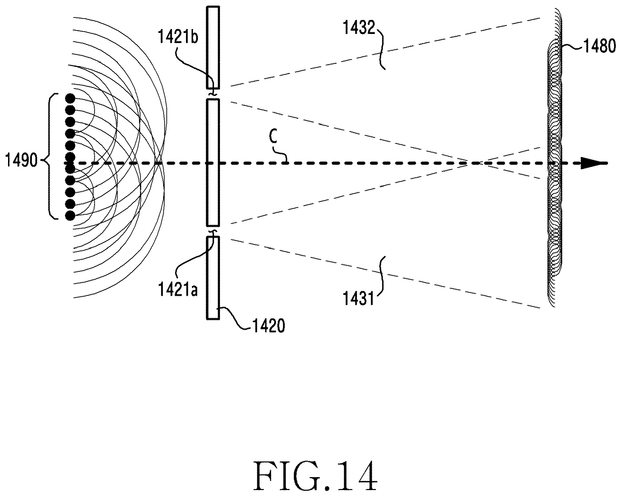

FIG. 14 is a schematic diagram of a sensor disposed on an electronic device according to an embodiment (for example, electronic device 300 in FIG. 3).

Referring to FIG. 14, the sensor module may include multiple light sources 1490. Light emitted by the multiple light sources 1490 may pass through intervals 1421a and 1421b or slots formed by a conductive pattern 1420 and may propagate along light paths 1431 and 1432 corresponding to respective intervals 1421a and 1421b or slits.

The light emitted from the multiple light sources 1490 may diffract when passing through respective slits, but unnecessary diffraction parts may counterbalance each other, and only light formed in the area corresponding to the center C of the multiple light sources 1490 may be finally maintained. Wavelengths 1480 formed by diffraction of light may counterbalance each other, thereby reducing the diffraction pattern, or preventing occurrence of the diffraction pattern.

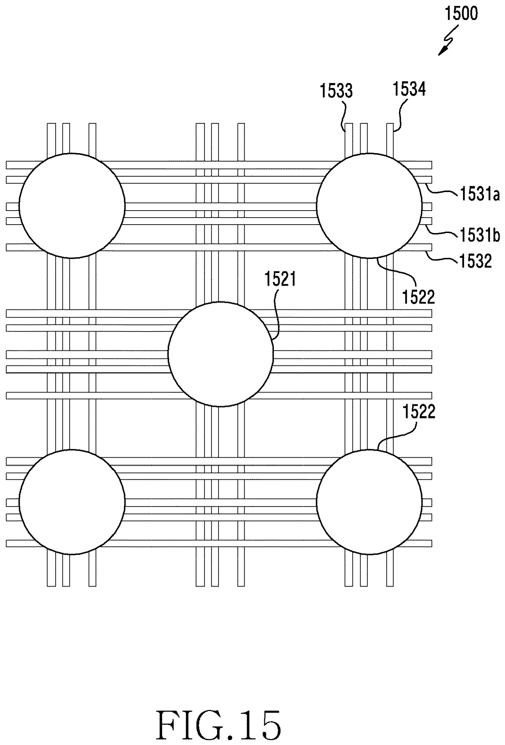

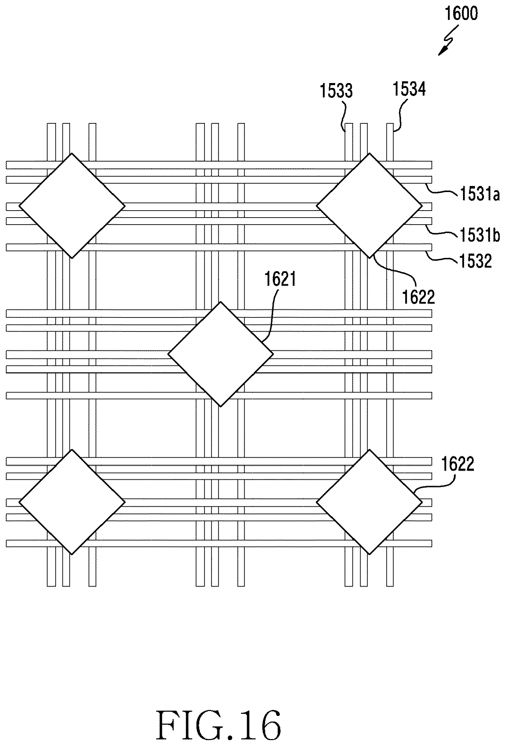

FIG. 15 is a diagram illustrating wires and conductive patterns of a display in connection with area B in FIG. 3 according to an embodiments. FIG. 16 is a diagram illustrating wires and conductive patterns of a display in connection with area B in FIG. 3 according to another embodiments.

Referring to FIG. 15 and FIG. 16, the displays 1500 and 1600 may include multiple wires 1531a, 1531b, 1532, 1533, and 1534 electrically connect organic light-emitting materials 1521, 1522, 1621, and 1622. The display 1500 may include an anode electrode (for example, anode electrode 529 in FIG. 5A) disposed beneath the organic light-emitting materials 1521 and 1522. The anode electrode may be made of an opaque metal, and light emitted by the sensor or light delivered to the sensor may be reflected by the anode electrode.

According to various embodiments, some of the multiple wires 1531a, 1531b, 1532, 1533, and 1534 may be signal transmission lines 1531a, 1531b, and 1533, and the remaining may be power supply lines 1532 and 1534. According to various embodiments, the multiple wires 1531a, 1531b, 1532, 1533, and 1534 may made of a conductive material so as to deliver a signal to a switch (for example, switch 523 in FIG. 5A), thereby driving the organic light-emitting materials 1521 and 1522. According to various embodiments, the multiple wires 1531a, 1531b, 1532, 1533, and 1534 may be made of a transparent material. For example, the multiple wires may include indium tin oxide (ITO) or indium zinc oxide (IZO).

The organic light-emitting materials 1521 and 1522 in FIG. 15 may be formed in a circular shape, and the organic light-emitting materials 1521 and 1522 in FIG. 15 may include an opaque conductive material (for example, metal such as gold or copper).

The organic light-emitting materials 1621 and 1622 in FIG. 16 may be formed in a polygonal shape, and the organic light-emitting materials 1621 and 1622 may include an opaque conductive material (for example, metal such as gold or copper). According to various embodiments, the intervals between the organic light-emitting materials 1621 and 1622, the areas thereof, or the shapes thereof may differ from each other.

According to various embodiments, in order to prevent diffraction of light through an interval between elements constituting a TFT, such as the switch in FIG. 5B or FIG. 5C (for example, switch 523 in FIG. 5B), an opaque member (for example, opaque member 559 in FIG. 5B) may be disposed on the organic light-emitting materials 1521, 1522, 1621, and 1622, or organic light-emitting materials 1521, 1522, 1621, and 1622 including an anode electrode (for example, anode electrode 529b in FIG. 5B) may be disposed on the switch.

According to various embodiments, the multiple wires 1531a, 1531b, 1532, 1533, and 1534 may be made of a transparent material. As a result, among the active areas of the displays 1500 and 1600, the area in which the organic light-emitting materials 1521, 1522, 1621, and 1622 are disposed may be an opaque area, and the remaining area may be a transparent area.

According to various embodiments, an opaque electrode such as a source electrode (for example, source electrode 524 in FIG. 5A), a semiconductor element (for example, semiconductor element 525 in FIG. 5A), a gate electrode (for example, gate electrode 526 in FIG. 5A), or a drain electrode (for example, drain electrode 527 in FIG. 5A), which constitutes a switch included in the organic light-emitting materials 1521, 1522, 1621, and 1622 that form an opaque area, and multiple wires 1531a, 1531b, 1532, 1533, and 1534 made of a transparent material may be connected directly without forming a separate contact hole. For example, the gate electrode 526 and some of the multiple transparent wires 1531a, 1531b, 1532, 1533, and 1534 may overlap each other and may thus be connected through direct physical contact. For example, the multiple wires 1531a, 1531b, 1532, 1533, and 1534 may be disposed only between respective organic light-emitting materials, and may not be formed in the area in which the organic light-emitting materials are disposed.

According to various embodiments, the multiple wires 1531a, 1531b, 1532, 1533, and 1534 made of a transparent conductive material may be formed so as to surround a surface of the gate electrode 526. For example, the multiple wires 1531a, 1531b, 1532, 1533, and 1534 may also be formed continuously in areas in which respective organic light-emitting materials are disposed.

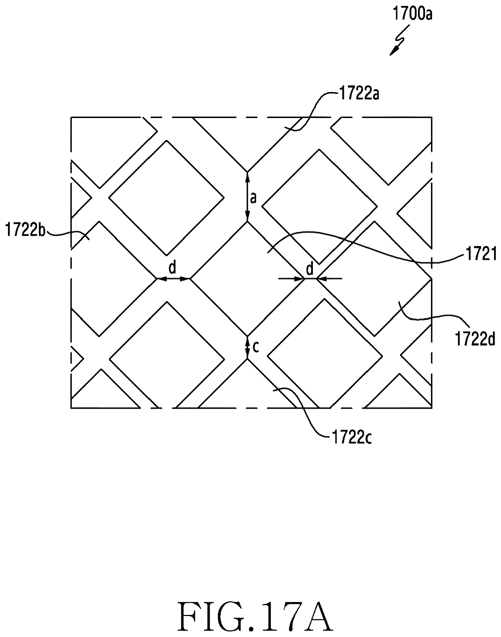

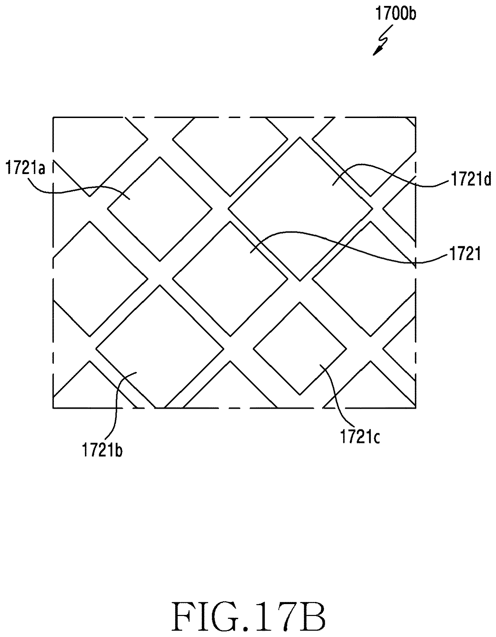

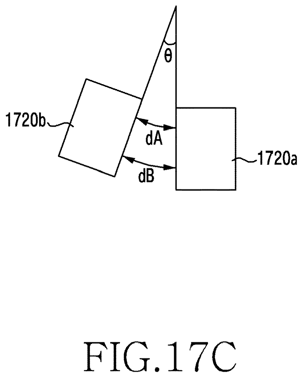

FIG. 17A is a diagram illustrating disposition of pixels in connection with the display in FIG. 16 according to an embodiments. FIG. 17B is a diagram illustrating disposition of pixels in connection with the display in FIG. 16 according to another embodiments. FIG. 17C is a diagram illustrating disposition of pixels in connection with the display in FIG. 16 according to another embodiments.

Referring to FIG. 17A, the display 1700a may include multiple organic light-emitting materials 1721, 1722a, 1722b, 1722c, and 1722d in area B in FIG. 3. With reference to an organic light-emitting material 1721, organic light-emitting materials 1722a, 1722b, 1722c, and 1722d disposed around the same may be formed to have different distances from the organic light-emitting material 1721. According to various embodiments, with reference to the organic light-emitting material 1721, the distance *a* from an adjacent first organic light-emitting material 1722a, the distance b from a second organic light-emitting material 1722b, the distance c from a third organic light-emitting material 1722c, and the distance d from a fourth organic light-emitting material 1722d may differ from one another.

Referring to FIG. 17B, the display 1700b may include multiple organic light-emitting materials 1721, 1721a, 1721b, 1721c, and 1721d in area B in FIG. 3. With reference to an organic light-emitting material 1721, organic light-emitting materials 1721a, 1721b, 1721c, and 1721d disposed around the same may be formed to have different sizes. According to various embodiments, with reference to an organic light-emitting material 1721, the size or area of an adjacent first organic light-emitting material 1721a, the size or area of a second organic light-emitting material 1721b, the size or area of a third organic light-emitting material 1721c, and the size or area of a fourth organic light-emitting material 1721d may differ from one another.

According to various embodiments, with reference to an organic light-emitting material 1721, organic light-emitting materials 1721a, 1721b, 1721c, and 1721d disposed around the same may be formed in different shapes.

Referring to FIG. 17C, facing edges of organic light-emitting materials 1720a and 1720b that are adjacent with reference to one organic light-emitting material included in the display may not be parallel with each other. According to various embodiments, the intervals between the organic light-emitting materials 1720a and 1720b that are adjacent with reference to one organic light-emitting material may be different. For example, respective organic light-emitting materials 1720a and 1720b may include first points that correspond to each other, and second points that correspond to each other in different positions. The distance dA between the first point of an organic light-emitting material 1720a and the first point of an adjacent organic light-emitting material 1720b may differ from the distance dB between the second point of the organic light-emitting material 1720a and the second point of the adjacent organic light-emitting material 1720b. As another example, facing edges of respective organic light-emitting materials 1720a and 1720b may form an angle Θ. That is, facing edges of the organic light-emitting materials may not be parallel with each other such that an edge of one organic light-emitting material 1720a may have an inclination with regard to an edge of another organic light-emitting material 1720b facing the same.

According to various embodiments, light emitted from a sensor disposed beneath the display in area B in FIG. 3 may diffract. In order to prevent diffraction occurring when light emitted by the sensor or light received by the sensor passes through the display 1700a, or in order to counterbalance light diffracted by the display, the interval between conductive patterns or electrodes disposed in the display may be formed in a non-regularized manner. If slits through which light passes (for example, interval between conductive patterns or electrodes) are formed in a non-regularized manner, various types of diffraction patterns may be formed, and rays of light diffracted after passing through respective slits may counterbalance each other.

An electronic device according to various embodiments described above may include: a sensor module configured to emit or detect light; and a display disposed above the sensor module, the display comprising a first area corresponding to a location of the sensor module and a second area which is a remaining area other than the first area.

According to various embodiments, the display may include: a pixel layer comprising pixels; an electrode layer disposed beneath the pixel layer, the electrode layer comprising electrodes electrically connected to the pixels; conductive patterns electrically connected to the pixels and the electrodes; and nonconductive patterns between the pixels.

According to various embodiments, the conductive patterns may be spaced apart from each other, at different intervals in the first area.

According to various embodiments, the nonconductive patterns may be spaced apart from each other, at different intervals in the first area.

According to various embodiments, the conductive patterns may include first conductive patterns formed in a first direction and second conductive patterns formed in a second direction perpendicular to the first direction.

According to various embodiments, in the first area, parts of each first conductive patterns may be parallel with each other, and other parts of each first conductive pattern may be curve and overlap each other.

According to various embodiments, the pixels may include subpixels, and the subpixels may be separated by the nonconductive patterns, and the subpixels in the first area may have a different shape, size, or disposition from the subpixels in the second area.

According to various embodiments, the nonconductive patterns may be disposed such that an interval between a first subpixel among subpixels disposed in the first area and a second subpixel adjacent to the first subpixel in a direction is different from an interval between the first subpixel and a third subpixel adjacent to the first subpixel in a different direction.

According to various embodiments, a first pixel included in the first area may include fewer subpixels than a second pixel included in the first area comprises identical subpixels as the second area.

According to various embodiments, the first pixel may include a one subpixel and an empty space adjacent to the one subpixel, the first conductive patterns or the second conductive patterns may be formed along an edge of the empty space, and the nonconductive patterns separate the empty space and the one subpixel.

According to various embodiments, the nonconductive patterns, the first conductive patterns, or the second conductive patterns may be disposed in the empty space may have different intervals from each other.

According to various embodiments, the conductive patterns may include a transparent wire made of a transparent material, and the transparent wire may be electrically connected to the electrodes.

According to various embodiments, the wire may include indium tin oxide (ITO) or indium zinc oxide (IZO).

According to various embodiments, the display may include multiple layers, and each of the multiple layers may include the conductive patterns or the nonconductive patterns.

According to various embodiments, shapes of the conductive patterns or the nonconductive patterns formed on at least one layer among the multiple layers may be different from shapes of the conductive patterns or the nonconductive patterns formed on remaining layers among the multiple layers.

According to various embodiments, the conductive patterns or the nonconductive patterns formed on at least one layer among the multiple layers may have different shapes.

According to various embodiments, in the first area, the display may include a filter configured to prevent scattering of light emitted or received by the sensor module.

According to various embodiments, the sensor module may include multiple light sources.

An electronic device according to various embodiments described above may include: a sensor module; and a display disposed above the sensor module, the display comprising a first area corresponding to a location of the sensor module and a second area which is a remaining area other than the first area.

According to various embodiments, the display may include: a pixel layer comprising pixels configured to emit light outwards; an electrode layer disposed beneath the pixel layer, the electrode layer comprising electrodes electrically connected to the pixels; conductive patterns electrically connected to the pixels and the electrodes; and nonconductive patterns separating the pixels, respectively.

According to various embodiments, in the first area, the display may include a filter configured to prevent scattering of light emitted or received by the sensor module.

According to various embodiments, the filter may be formed on one of multiple layers included in the display.

According to various embodiments, the filter may be formed as at least one pattern around a light source or light-receiving portion of the sensor module.

According to various embodiments, the filter may be disposed along a periphery of the light source or the light-receiving portion.

According to various embodiments, the at least one pattern may be formed in a shape corresponding to a diffraction pattern of light delivered to the sensor module.

Methods disclosed in the claims and/or methods according to various embodiments described in the specification of the disclosure may be implemented by hardware, software, or a combination of hardware and software.

When the methods are implemented by software, a computer-readable storage medium for storing one or more programs (software modules) may be provided. The one or more programs stored in the computer-readable storage medium may be configured for execution by one or more processors within the electronic device. The at least one program may include instructions that cause the electronic device to perform the methods according to various embodiments of the disclosure as defined by the appended claims and/or disclosed herein.

The programs (software modules or software) may be stored in non-volatile memories including a random access memory and a flash memory, a read only memory (ROM), an electrically erasable programmable read only memory (EEPROM), a magnetic disc storage device, a compact disc-ROM (CD-ROM), digital versatile discs (DVDs), or other type optical storage devices, or a magnetic cassette. Alternatively, any combination of some or all of them may form a memory in which the program is stored. Further, a plurality of such memories may be included in the electronic device.

In addition, the programs may be stored in an attachable storage device which may access the electronic device through communication networks such as the Internet, Intranet, Local Area Network (LAN), Wide LAN (WLAN), and Storage Area Network (SAN) or a combination thereof. Such a storage device may access the electronic device via an external port. Further, a separate storage device on the communication network may access a portable electronic device.

In the above-described detailed embodiments of the disclosure, an element included in the disclosure is expressed in the singular or the plural according to presented detailed embodiments. However, the singular form or plural form is selected appropriately to the presented situation for the convenience of description, and the disclosure is not limited by elements expressed in the singular or the plural. Therefore, either an element expressed in the plural may also include a single element or an element expressed in the singular may also include multiple elements.

Although specific embodiments have been described in the detailed description of the disclosure, modifications and changes may be made thereto without departing from the scope of the disclosure. Therefore, the scope of the disclosure should not be defined as being limited to the embodiments, but should be defined by the appended claims and equivalents thereof.

## Claims

1. An electronic device comprising:
a sensor module configured to emit or detect light; and
a display disposed above the sensor module, the display comprising a first area corresponding to a location of the sensor module and a second area which is a remaining area other than the first area,
wherein the display comprises:
a pixel layer comprising pixels;
an electrode layer disposed beneath the pixel layer, the electrode layer comprising electrodes electrically connected to the pixels;
conductive patterns electrically connected to the pixels and the electrodes; and
nonconductive patterns between the pixels,
wherein the conductive patterns are spaced apart from each other, at different intervals in the first area, and
wherein the nonconductive patterns are spaced apart from each other, at different intervals in the first area.

2. The electronic device of claim 1, wherein the conductive patterns comprise first conductive patterns formed in a first direction and second conductive patterns formed in a second direction perpendicular to the first direction.

3. The electronic device of claim 2, wherein, in the first area, parts of each first conductive patterns are parallel with each other, and other parts of each first conductive pattern curve and overlap each other.

4. The electronic device of claim 2, wherein the pixels comprise subpixels, and wherein the subpixels are separated by the nonconductive patterns, and the subpixels in the first area have a different shape, size, or disposition from the subpixels in the second area.

5. The electronic device of claim 4, wherein the nonconductive patterns are disposed such that an interval between a first subpixel among subpixels disposed in the first area and a second subpixel adjacent to the first subpixel in a direction is different from an interval between the first subpixel and a third subpixel adjacent to the first subpixel in a different direction.

6. The electronic device of claim 4, wherein a first pixel included in the first area comprises fewer subpixels than a second pixel included in the first area comprises identical subpixels as the second area.

7. The electronic device of claim 6, wherein the first pixel comprises a one subpixel and an empty space adjacent to the one subpixel, the first conductive patterns or the second conductive patterns are formed along an edge of the empty space, and the nonconductive patterns separate the empty space and the one subpixel.

8. The electronic device of claim 6, wherein the nonconductive patterns, the first conductive patterns, or the second conductive patterns disposed in the empty space have different intervals from each other.

9. The electronic device of claim 1, wherein the display comprises multiple layers, and each of the multiple layers comprise the conductive patterns or the nonconductive patterns.

10. The electronic device of claim 9, wherein shapes of the conductive patterns or the nonconductive patterns formed on at least one layer among the multiple layers are different from shapes of the conductive patterns or the nonconductive patterns formed on remaining layers among the multiple layers.

11. The electronic device of claim 9, wherein the conductive patterns or the nonconductive patterns formed on at least one layer among the multiple layers have different shapes.

12. The electronic device of claim 1, wherein, in the first area, the display comprises a filter configured to prevent scattering of light emitted or received by the sensor module.

13. The electronic device of claim 12, wherein the display comprises multiple layers, and the filter is formed on one of the multiple layers.

14. The electronic device of claim 12, wherein the filter is formed as at least one pattern around of the sensor module.

15. The electronic device of claim 14, wherein the at least one pattern is formed in a shape corresponding to a diffraction pattern of light detected by the sensor module.
